# EUROPEAN PATENT SPECIFICATION

(11) **EP 1 951 016 B1**
(45) Date of publication and mention of the grant of the patent: **29.05.2013**
(21) Application number: 06822610.9
(22) Date of filing: 30.10.2006
(51) Int. Cl.: H05K 3/46, H05K 1/02, H05K 3/00, H05K 3/40

(54) **FLEX-RIGID WIRING BOARD AND METHOD FOR MANUFACTURING THE SAME**
FLEX-STARRE LEITERPLATTE UND HERSTELLUNGSVERFAHREN DAFÜR
CARTE DE CÂBLAGE FLEXORIGIDE ET PROCÉDÉ DE FABRICATION CORRESPONDANT

(43) Date of publication of application: 30.07.2008
(73) Proprietor: Ibiden Co., Ltd., Ogaki-shi Gifu 503-8604 (JP)
(72) Inventor: TAKAHASHI, Michimasa, Ogaki-shi Gifu 503-8503 (JP); AOYAMA, Masakazu, Ogaki-shi Gifu 503-8503 (JP)
(74) Representative: HOFFMANN EITLE
(86) International application number: PCT/JP2006/321681
(87) International publication number: WO 2008/053520

(56) References cited:
- WO-A1-93/11652
- DE-C1- 4 208 610
- JP-A- 07 094 835
- JP-A- 63 293 991
- JP-A- 2006 100 704
- JP-A- 2006 196 800
- US-A- 4 715 928

## Description

### Technical Field

The present invention relates to a bendable wiring board which is partly formed of a flexible substrate and a manufacturing method of the wiring board.

### Background Art

A flex-rigid wiring board, a part of which has rigidity, and the other part of which has flexibility, has been disclosed, for example, in Unexamined Japanese Patent Application KOKAI Publication No. 2006-140213, Unexamined Japanese Patent Application KOKAI Publication No. 2006-100703 and International Publication No. WO2004/093508.

The flex-rigid wiring board disclosed in Unexamined Japanese Patent Application KOKAI Publication No. 2006-140213 has core substrates which are rigid portions, a flexible substrate disposed adjacent to the core substrates in a horizontal direction, flexible adhesive layers laminated on the core substrates and the flexible substrate, wiring patterns formed on the flexible adhesive layers located on the rigid portions, and blind vias and/or through-holes connecting the wiring patterns formed on individual layers.

In the structure described above, the flexible adhesive layer is laminated on the flexible substrate. Accordingly, when the flexible substrate is bent, a large stress is generated. As a result, a force applied to a connection portion between a conductor of the flexible substrate and a conductor of the rigid substrate is large, and for example, wire breakage is liable to occur.

In Unexamined Japanese Patent Application KOKAI Publication No. 2006-100703, the following method for manufacturing a flex-rigid wiring board has been disclosed. First, rigid substrates each having a vertical wiring portion in a connection region and a flexible substrate having connection terminals formed at end portions are separately formed. Subsequently, the connection regions of the rigid substrates are each machined to form a cut-off portion having a depth larger than the thickness of the flexible substrate, thereby forming steps. Next, the connection terminals of the flexible substrate are connected to the vertical wiring portions at the steps.

In this manufacturing method, connection of a conductor of the flexible substrate with a conductor of the rigid substrate is weak.

Furthermore, in the flex-rigid wiring board disclosed in International Publication No. WO2004/093508, a rigid substrate and a flexible substrate are polymerized with an insulating adhesive interposed therebetween so as to be integrated. In addition, connection electrode pads of the rigid and the flexible substrates are electrically and physically connected to each other with a block-shaped conductor provided therebetween which penetrates the insulating adhesive.

In the flex-rigid wiring board having the above structure, the flexible substrate is disposed at one side of the rigid substrate, a via is formed from the flexible substrate side by laser irradiation, and connection is formed by plating; hence, a bending portion is held only at one side. As a result, connection reliability of the plating connection portion is inferior.

WO 93/11652; US Patent 4,715,928; and DE 4208610 C1 each disclose a flex-rigid wiring board useful for understanding the background to the disclosed invention.

### Disclosure of Invention

### Problem to be Solved by the Invention

The present invention has been conceived in consideration of the current situation, and an advantage obtainable with embodiments of the present invention is to provide a flex-rigid wiring board having high reliability, in particular, high connection reliability and is to provide a manufacturing method thereof.

In addition, another advantage obtainable with embodiments of the present invention is to provide a flex-rigid wiring board which is inexpensive and which can be easily manufactured and is to provide a manufacturing method thereof.

### Summary of the invention

According to the present invention, there is provided a flex-rigid wiring board as recited in Claim 1 below.

Dependent claims therefrom are directed to particular embodiments.

According to a further aspect of the present invention, there is provided a method for manufacturing a flex-rigid wiring board as recited in Claim 37 below.

Dependant claims therefrom are directed to particular embodiments.

According to the invention, a first and a second insulating layers each contain an inorganic material. Hence, the first and the second insulating layers having high rigidity can be provided, thereby improving the rigidity of the rigid portion of a flex-rigid wiring board.

### Brief Description of Drawings

To better understand the disclosed invention and to show how the same may be carried into effect, reference will now be made, by way of example only, to the accompanying Drawings, in which:
[Fig. 1A] Fig. 1A is a side view of a flex-rigid wiring board according to a first embodiment of the present invention.
[Fig. 1B] Fig. 1B is a plan view of a flex-rigid wiring board according to a first embodiment of the present invention.
[Fig. 2] Fig. 2 is a partly enlarged view of Fig. 1A.
[Fig. 3] Fig. 3 is a view showing a modification of the flex-rigid wiring board shown in Fig. 2.
[Fig. 4] Fig. 4 is a side view of a flexible substrate.
[Fig. 5A] Fig. 5A shows a flowchart illustrating a manufacturing method of a flex-rigid wiring board according to an embodiment of the present invention.
[Fig. 5B] Fig. 5B shows a flowchart illustrating a manufacturing method of a flex-rigid wiring board according to an embodiment of the present invention.
[Fig. 5C] Fig. 5C shows a flowchart illustrating a manufacturing method of a flex-rigid wiring board according to an embodiment of the present invention.
[Fig. 5D] Fig. 5D shows a flowchart illustrating a manufacturing method of a flex-rigid wiring board according to an embodiment of the present invention.
[Fig. 5E] Fig. 5E shows a flowchart illustrating a manufacturing method of a flex-rigid wiring board according to an embodiment of the present invention.
[Fig. 5F] Fig. 5F shows a flowchart illustrating a manufacturing method of a flex-rigid wiring board according to an embodiment of the present invention.
[Fig. 5G] Fig. 5G shows a flowchart illustrating a manufacturing method of a flex-rigid wiring board according to an embodiment of the present invention.
[Fig. 5H] Fig. 5H shows a flowchart illustrating a manufacturing method of a flex-rigid wiring board according to an embodiment of the present invention.
[Fig. 5I] Fig. 5I shows a flowchart illustrating a manufacturing method of a flex-rigid wiring board according to an embodiment of the present invention.
[Fig. 5J] Fig. 5J shows a flowchart illustrating a manufacturing method of a flex-rigid wiring board according to an embodiment of the present invention.
[Fig. 5K] Fig. 5K shows a flowchart illustrating a manufacturing method of a flex-rigid wiring board according to an embodiment of the present invention.
[Fig. 5L] Fig. 5L shows a flowchart illustrating a manufacturing method of a flex-rigid wiring board according to an embodiment of the present invention.
[Fig. 6A] Fig. 6A is an enlarged view illustrating the manufacturing method of a flex-rigid wiring board, which is illustrated with reference to Figs. 5A to 5L.
[Fig. 6B] Fig. 6B is an enlarged view illustrating the manufacturing method of a flex-rigid wiring board, which is illustrated with reference to Figs. 5A to 5L.
[Fig. 6C] Fig. 6C is an enlarged view illustrating the manufacturing method of a flex-rigid wiring board, which is illustrated with reference to Figs. 5A to 5L.
[Fig. 6D] Fig. 6D is an enlarged view illustrating the manufacturing method of a flex-rigid wiring board, which is illustrated with reference to Figs. 5A to 5L.
[Fig. 6E] Fig. 6E is an enlarged view illustrating the manufacturing method of a flex-rigid wiring board, which is illustrated with reference to Figs. 5A to 5L.
[Fig. 6F] Fig. 6F is an enlarged view illustrating the manufacturing method of a flex-rigid wiring board, which is illustrated with reference to Figs. 5A to 5L.
[Fig. 7] Fig. 7 is a view showing modifications of the flex-rigid wiring board shown in Fig. 3.
[Fig. 8] Fig. 8 is a view showing modifications of the flex-rigid wiring board shown in Fig. 3.
[Fig. 9A] Fig. 9A is a view showing a modification of the flex-rigid wiring board shown in Fig. 2.
[Fig. 9B] Fig. 9B is a view showing a modification of the flex-rigid wiring board shown in Fig. 2.
[Fig. 10A] Fig. 10A is a view showing a modification of the flex-rigid wiring board shown in Fig. 3.
[Fig. 10B] Fig. 10B is a view showing a modification of the flex-rigid wiring board shown in Fig. 3.
[Fig. 11A] Fig. 11A shows a step illustrating a manufacturing method of the flex-rigid wiring board shown in Fig. 10A.
[Fig. 11B] Fig. 11B shows a step illustrating a manufacturing method of the flex-rigid wiring board shown in Fig. 10A.
[Fig. 11C] Fig. 11C shows a step illustrating a manufacturing method of the flex-rigid wiring board shown in Fig. 10A.
[Fig. 11D] Fig. 11D shows a step illustrating a manufacturing method of the flex-rigid wiring board shown in Fig. 10A.
[Fig. 11E] Fig. 11E shows a step illustrating a manufacturing method of the flex-rigid wiring board shown in Fig. 10A.
[Fig. 11F] Fig. 11F shows a step illustrating a manufacturing method of the flex-rigid wiring board shown in Fig. 10A.
[Fig. 12A] Fig. 12A shows a step illustrating a manufacturing method of the flex-rigid wiring board shown in Fig. 10B.
[Fig. 12B] Fig. 12B shows a step illustrating a manufacturing method of the flex-rigid wiring board shown in Fig. 10B.
[Fig. 12C] Fig. 12C shows a step illustrating a manufacturing method of the flex-rigid wiring board shown in Fig. 10B.
[Fig. 12D] Fig. 12D shows a step illustrating a manufacturing method of the flex-rigid wiring board shown in Fig. 10B.
[Fig. 12E] Fig. 12E shows a step illustrating a manufacturing method of the flex-rigid wiring board shown in Fig. 10B.
[Fig. 12F] Fig. 12F shows a step illustrating a manufacturing method of the flex-rigid wiring board shown in Fig. 10B.
[Fig. 13A] Fig. 13A shows a modification of the flex-rigid wiring board shown in Fig. 7.
[Fig. 13B] Fig. 13B shows a modification of the flex-rigid wiring board shown in Fig. 7.
[Fig. 14A] Fig. 14A shows a modification of the flex-rigid wiring board shown in Fig. 8.
[Fig.14B] Fig. 14B shows a modification of the flex-rigid wiring board shown in Fig. 8.

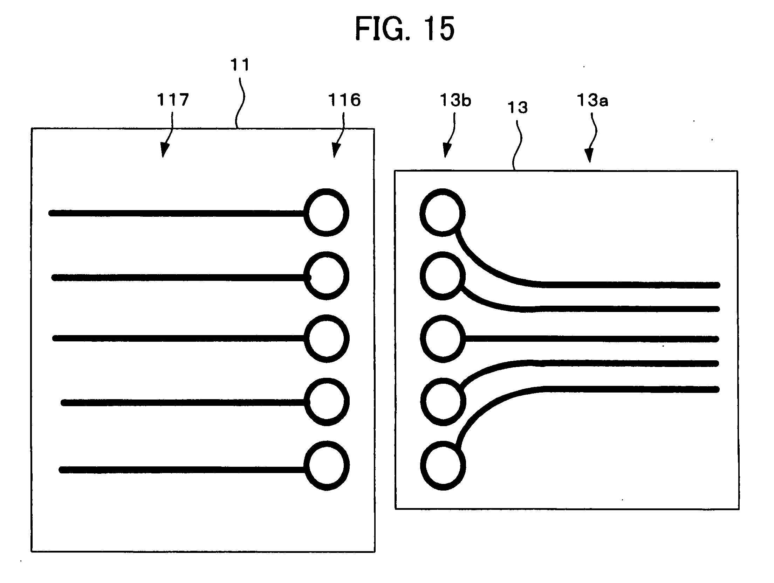

[Fig. 15] Fig. 15 is a view showing an example in which a wiring pattern is fanned out.
[Fig. 16] Fig. 16 is a view showing an example in which the strength is increased by forming a part of a flexible substrate to have a large width.
[Fig. 17] Fig. 17 is a view showing an example in which the strength is increased by forming a part of a flexible substrate to have a large width.

### Detailed Description

10 flex-rigid wiring board
11, 12 rigid substrate
13 flexible substrate
111, 113 insulating layer
111a, 113a glass cloth
111b, 113b inorganic material
112 non-flexible base material
114, 115, 144, 145 upper insulating layer

Hereinafter, a flex-rigid wiring board 10 according to a first embodiment of the present invention will be described.

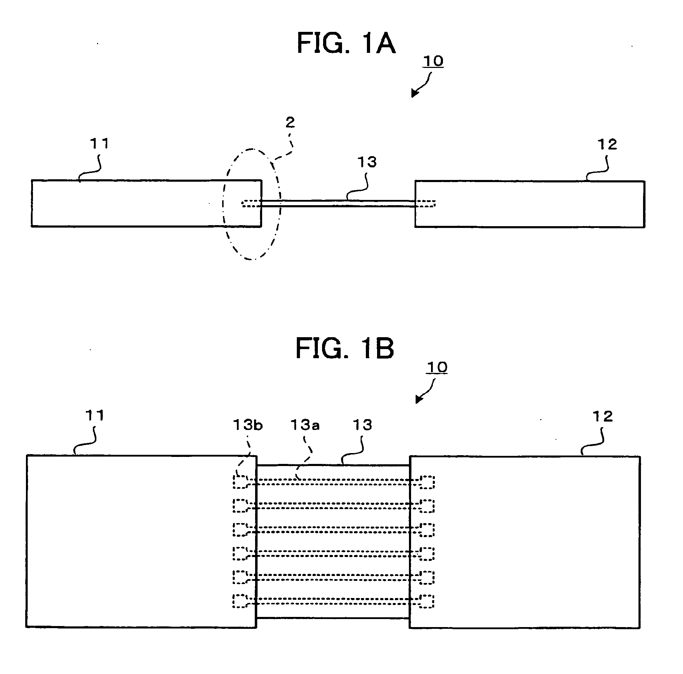

As shown in Figs. 1A and 1B, the flex-rigid wiring board 10 of this embodiment is composed of a first rigid substrate (rigid substrate) 11, a second rigid substrate 12, and a flexible substrate (flexible substrate) 13 connecting the rigid substrates 11 and 12.

On the first and the second rigid substrates 11 and 12, optional circuit patterns are formed. In addition, whenever necessary, for example, electronic elements, such as a semiconductor chip, are connected.

On the flexible substrate 13, a stripe wire 13a is formed to connect the first rigid circuit 11 and the circuit pattern of the second substrate 12. Hence, the wire 13a connects the circuit pattern of the rigid substrate 11 and the circuit pattern of the rigid substrate 12.

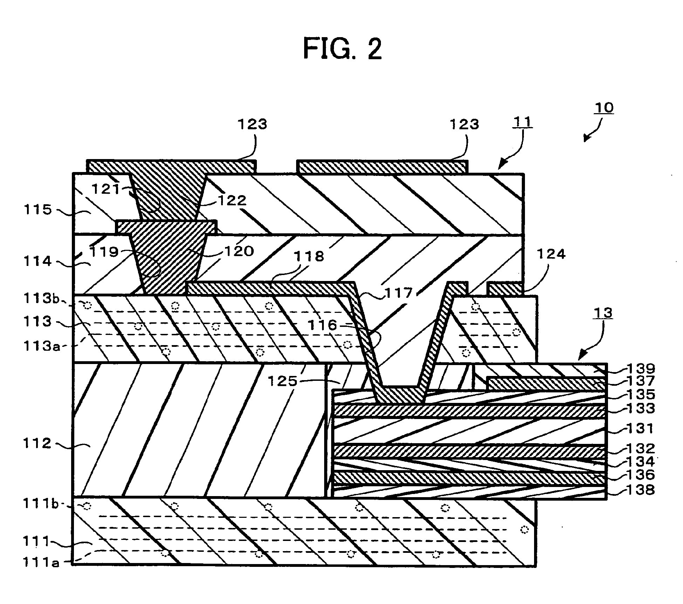

Next, as for the structure of a connection portion of the flexible substrate 13 with the rigid substrate 11 or 12, the connection portion between the rigid substrate 11 and the flexible substrate 13 will be described in detail by way of example with reference to Fig. 2. Fig. 2 is an enlarged cross-sectional view of an area represented by reference numeral 2 of Fig. 1A.

As shown in the figure, the flexible substrate 13 has the structure in which a base material 131, conductive layers 132 and 133, insulating layers 134 and 135, shield layers 136 and 137, and cover lays 138 and 139 are laminated.

The base material 131 is formed of an insulating flexible sheet, such as a polyimide sheet having a thickness of 20 to 50 µm and preferably having a thickness of approximately 30 µm.

The conductive layers 132 and 133 are formed on the front surface and the rear surface of the base material 131, respectively, so that the stripe wire pattern 13a is formed. The conductive layers 132 and 133 are each formed, for example, of a copper pattern having a thickness of approximately 5 to 15 µm.

The insulating layers 134 and 135 are each formed, for example, of a polyimide film having a thickness of approximately 5 to 15 µm and insulate the conductive layers 132 and 133 from the outside.

The shield layers 136 and 137 are formed of conductive layers, such as cured films made from a silver paste, to shied electromagnetic noises to the conductive layers 132 and 133 from the outside and to shield electromagnetic noises to the outside from the conductive layers 132 and 133.

The cover lays 138 and 139 are each formed of an insulating film made, for example, of a polyimide film having a thickness of approximately 5 to 15 µm, and protect the whole flexible substrate 13 besides the electrical insulation thereof from the outside.

On the other hand, the ridge substrate 11 is formed of a first insulating layer 111, a non-flexible base material 112, a second insulating layer 113, a first upper insulating layer 114, and a second upper insulating layer 115, which are laminated to each other.

The non-flexible base material 112 imparts rigidity to the rigid substrate 11 and is formed of a non-flexible insulating material such as a glass epoxy resin. The non-flexible base material 112 is disposed apart from the flexible substrate 13 in a horizontal direction. The non-flexible base material 112 is formed to have a thickness approximately equivalent to that of the flexible substrate 13, such as 50 to 150 µm or preferably approximately 100 µm.

The first and the second insulating layers 111 and 113 are formed by curing prepregs. The first and the second insulating layers 111 and 113 each have a thickness of 50 to 100 µm or preferably approximately 50 µm.

The above prepregs are preferably formed of a resin having low flow properties. The prepregs as described above can be formed by impregnating glass clothes 111a and 113a, each of which is an inorganic material, with an epoxy resin, followed by thermal curing of the resin to increase the curing degree thereof beforehand. Furthermore, inorganic materials 111b and 113b, such as silica filler or glass filler, may be added to the resin.

In addition, the prepregs described above can also be formed by impregnating glass clothes with a resin having a high viscosity, impregnating glass clothes with a resin containing inorganic filler such as silica filler, or by decreasing the amount of a resin to be used for impregnation of glass clothes.

The first and the second insulating layers 111 and 113 cover the front and the rear surface sides of the non-flexible base material 112 and the flexible substrate 13 and partly expose the flexible substrate 13. In addition, the first and the second insulating layers 111 and 113 are polymerized together with the cover lays 138 and 139 which are the surfaces of the flexible substrate 13.

The non-flexible base material 112 and the first and the second insulating layers 111 and 113 form a core of the rigid substrate 11 to support the rigid substrate 11 and also support and fix the flexible substrate 13 by sandwiching one end portion thereof.

The non-flexible base material 112, the flexible substrate 13, and the first and the second insulating layers 111 and 113 form a space, and a resin 125 is filled in this space. The resin 125 is, for example, a resin oozing in manufacturing from low-flow prepregs forming the first and the second insulating layers 111 and 113 and is integrally cured together with the first and the second insulating layers 111 and 113. Hence, the resin 125 also includes an inorganic material.

Furthermore, in a part of the second insulating layer 113 corresponding to a connection pad 13b of the wire 133 of the flexible substrate 13, a via (via hole, contact hole) 116 is formed.

Of the flexible substrate 13, at a part corresponding to the via 116 (part at which the connection pad 13b of the conductive layer 13a is formed), the shield layer 137 and the cover lay 139 of the flexible substrate 13 are removed. The via 116 penetrates the insulating layer 135 of the flexible substrate 13 and exposes the connection pad 13b of the conductive layer 133.

Inside the via 116, a conductive layer 117 made by copper plating or the like is formed. The conductive layer 117 is connected to the connection pad 13b of the conductor layer 133 of the flexible substrate 13 by plating. In addition, the via 116 is filled with a resin, such as a resin containing an inorganic material.

On the second insulating layer 113, a lead pattern 118 connected to the conductive layer 117 is formed. The lead pattern 118 is formed of a copper plating layer or the like.

In addition, at a front end of the second insulating layer 113, that is, at a position extending over a boundary between the flexible substrate 13 and the non-flexible base material 112, a copper pattern 124 isolated from the others is disposed. Hence, heat generated in the rigid substrate 11 can be effectively dissipated.

The first upper insulating layer 114 is disposed so as to be laminated on the second insulating layer 113. The first upper insulating layer 114 is formed by curing a material containing an inorganic material, such as silica filler, glass filler, carbon fibers, or ceramic fibers, e.g., prepregs containing glass clothes impregnated with a resin. By the structure as described above, falling impact resistance can be improved.

In addition, on the first upper insulating layer 114, the second upper insulating layer 115 is disposed. The second upper insulating layer 115 is formed by curing prepregs made of glass clothes impregnated with a resin containing an inorganic material such as silica filler or glass filler.

In the first upper insulating layer 114 disposed on the second insulating layer 113, a via (first upper via) 119 connected to the lead pattern 118 is formed. The via 119 is filled with a conductor 120 made of copper or the like. In addition, in the second upper insulating layer 115 laminated on the first upper insulating layer 114, a via (second upper via) 121 connected to the via 119 is formed. The via 121 is filled with a conductor 121 made of copper or the like. That is, by the vias 119 and 121, a filled buildup via is formed.

On the second upper insulating layer 115, a conductive pattern (circuit pattern) 123 is optionally formed. The via 119 is also optionally connected to the above conductive pattern 123.

In addition, the structure of a connection portion between the rigid substrate 12 and the flexible substrate 13 is the same as that between the rigid substrate 11 and the flexible substrate 13.

In the flex-rigid wiring board 10 having the above structure, the end portion of the flexible substrate 13 is sandwiched by the first and the second insulating layers 111 and 113 forming the core portion of the rigid substrate 11 and is polymerized.

Furthermore, the connection pad 13b of the conductive layer 133 of the flexible substrate 13 and the conductive pattern 123 of the rigid substrate 11 are connected to each other with the copper plating layer 117 formed in the via 116 which is formed in the second insulating layer 113 and the insulating layer 135.

Hence, when the flexible substrate 13 is bent, a stress applied thereto is not transmitted to the connection portion (via 116 and the wire layer 117) of the rigid substrate 11. As a result, a stress applied to the connection portion between the rigid substrate 11 and the flexible substrate 13 is small, and hence the reliability is high.

In particular, the insulating layers 111 and 113 contain the inorganic materials 111a, 111b, 113a and 113b, such as glass clothes, silica filler, glass filler, carbon fibers, and ceramic fibers. The inorganic materials mentioned above have high rigidity as compared to that of an organic material. Hence, compared to the case in which the insulating layers 111 and 113 are entirely formed of a resin, the rigidity of the films of the insulating layers 111 and 113 is high. Accordingly, even when the flexible substrate 13 is bent, the core is not substantially deformed. As a result, a stress is not likely to be transmitted to the connection portion between the rigid substrate 11 and the flexible substrate 13.

In addition, as the inorganic material, particularly, glass cloth is preferable. Compared to any inorganic material other than glass cloth, the glass cloth can most improve the rigidity of the insulating layers 111 and 113. Accordingly, in the case in which the insulating layers 111 and 113 contain the glass clothes 111a and 113b, even when the flexible substrate 13 is bent, the core is not deformed, and hence, a stress is not likely to be transmitted to the connection portion between the flexible substrate 13 and the rigid substrate 11.

In addition, the conductive layer 133 of the flexible substrate 13 and the wire layer 117 inside the via 116 of the rigid substrate 11 are connected to each other by plating. Hence, the reliability of the connection portion is high.

Furthermore, in the via 116, the resin of the upper insulating layer 114 is filled. Since the via 116 is fixed and supported by the resin therein, the connection reliability between the via 116 and the conductive layer 133 is improved.

In addition, the end surfaces of the insulating layers 113 and 111 at the flexible substrate side protrude than the end surface of the upper insulating layer 114 at the flexible substrate side. Hence, when the flexible substrate 13 is bent, a stress applied to the flexible substrate 13 is not transmitted to the connection portion (the via 116 and the wire layer 117) of the rigid substrate 11. As a result, a stress applied to the connection portion between the rigid substrate 11 and the flexible substrate 13 is small, and hence the reliability is high.

In addition, the structure is formed so that the core portion of the rigid substrate 11 suppresses expansion and contraction of the flexible substrate 13, which tends to expand and contract, in a horizontal direction. Hence, bending reliability and heat-resistance reliability are high. Since a flexible base material portion of the flexible substrate 13 is exposed between the rigid substrates 11 and 12, compared to the case in which the entire is covered with an insulating resin or the like, when bending is performed, a stress applied to wires or the like is small.

In addition, the flex-rigid wiring board 10 has the structure in which the end portion of the flexible substrate 13 is sandwiched by the first and the second insulating layers 111 and 113 of the rigid substrate 11. Hence, the influence of change in dimension of the flexible substrate 13 is small, and as a result, for example, the error in placement position of a connection land (via 116) of the rigid substrate 11 can be decreased. Accordingly, the diameter of the via 116 can also be designed to be small.

In addition, the insulating layers 111 and 113 contain inorganic materials 111a, 111b, 113a and 113b, such as glass clothes, silica filler, glass filler, carbon fibers, and ceramic fibers. Compared to a resin which is an organic material, the inorganic materials mentioned above have a small coefficient of thermal expansion and small expansion and contraction. Hence, compared to the case in which the insulating layers 111 and 113 are entirely formed of a resin, the positional deviation of the connection land is small, and the connection land can be formed to be small.

In addition, in the rigid substrates 11 and 12, the flexible substrate 13 is not disposed. Hence, reliability approximately equivalent to that of a conventional rigid substrate can be maintained. In addition, resistance against a plating solution is high, and hence a general plating solution can be used. Since a flexible material is also not used for the rigid portion, heat resistance equivalent to that of a general rigid portion can be maintained.

Furthermore, since the flexible base material 13 is partly used and is effectively disposed, the manufacturing cost can be reduced.

The upper insulating layers 114 and 115 are formed of general prepregs. The general prepregs have good conformity with interlayer patterns when being provided therebetween. Hence, insulation degradation caused, for example, by generation of voids can be avoided. In addition, a fine pattern (L/S=60/60, 50/50 µm) can be realized. Furthermore, material control can be performed in a restricted manner.

In addition, as the upper insulating layers 114 and 115, a general interlayer material (prepregs) is used. Hence, in a manufacturing process, IVH (Interstitial Via Hole) including the via 116 can be filled with a resin forming the upper insulating layers 114 and 115. As a result, a resin exclusively used for filling the via is not necessary.

Since a glass epoxy base material is used for the core portion of the rigid substrates 11 and 12, falling impact resistance can be improved.

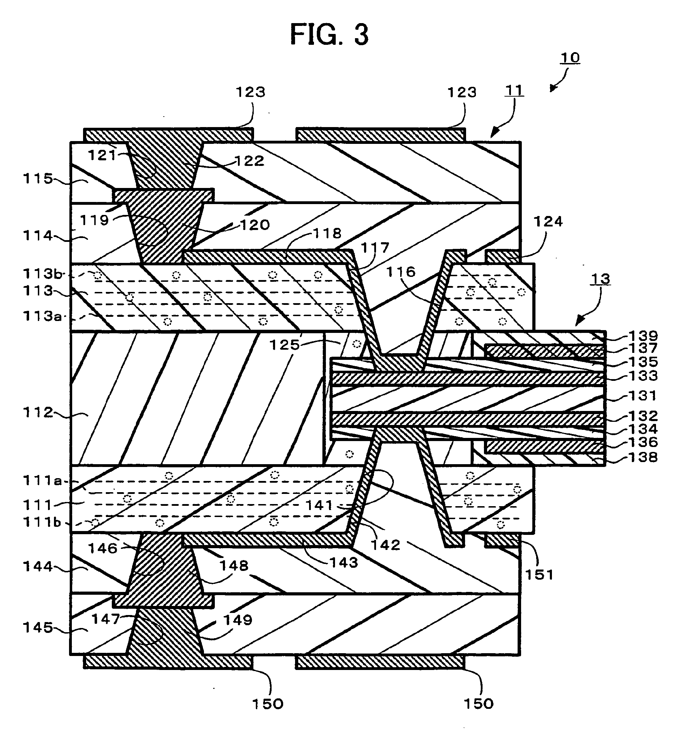

In this embodiment, in order to facilitate the understanding, only on the upper surfaces of the rigid substrates 11 and 12, the conductive patterns are formed. However, the present invention is not limited to the above embodiment. For example, as shown in Fig. 3, conductive patterns may be disposed at the lower sides of the rigid substrates 11 and 12.

In the structure shown in Fig. 3, a via 141 is formed in the first insulating layer 111 and the insulating layer 134 of the flexible substrate 13. In the via 141, a conductive pattern 142 is formed and is connected to a lead pattern 143 formed on the first insulating layer 111. The conductive pattern 142 and the lead pattern 143 are formed by patterning a copper plating layer.

On the first insulating layer 111, third and fourth insulating layers 144 and 145, which contain an inorganic material, are laminated. In the third and fourth insulating layers 144 and 145, vias 146 and 147 are formed. The vias 146 and 147 are filled with conductors 148 and 149. On the upper insulating layer 145, a conductive pattern 150 is formed.

Next, a method for manufacturing the flex-rigid wiring board 10 having the above structure will be described.

First, a method for manufacturing the flexible substrate 13 will be described.
Copper films are formed on two surfaces of the polyimide base material 131 having a predetermined size. Next, by patterning the copper films, the conductive layers 132 and 133 are formed which include the wire patterns 13a and the connection pads 13b.

On the polyimide base material 131 and the two conductive layers 132 and 133, the insulating films 134 and 135 each made of a polyimide layer or the like are formed. In addition, a silver paste is applied to the flexible substrate 13 other than the end portion thereof and is then cured, so that the shield layers 136 and 137 are formed.

Subsequently, the cover lays 138 and 139 are formed so as to cover the shield layers 136 and 137, which are located at the front surface and the rear surface sides, respectively.

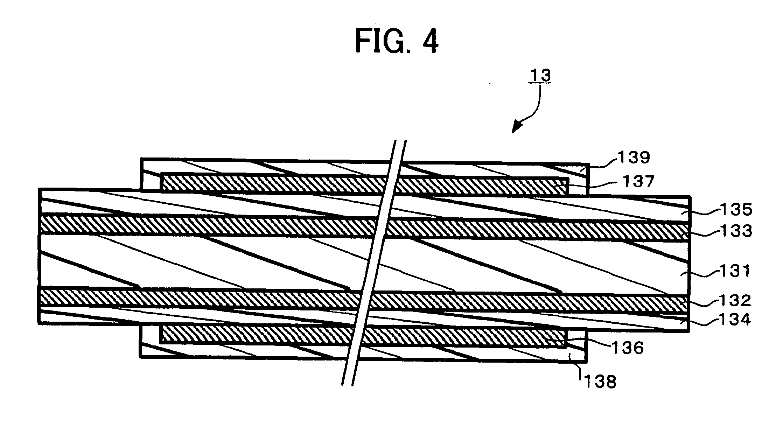

As described above, the flexible substrate 13 having the structure shown in Fig. 4 is formed. In this structure, the shield layers 136 and 137 and the cover lays 138 and 139 are formed at places other than those for the connection pads 13b.

Next, a method for bonding the rigid substrates 11 and 12 to the flexible substrate 13 will be described.

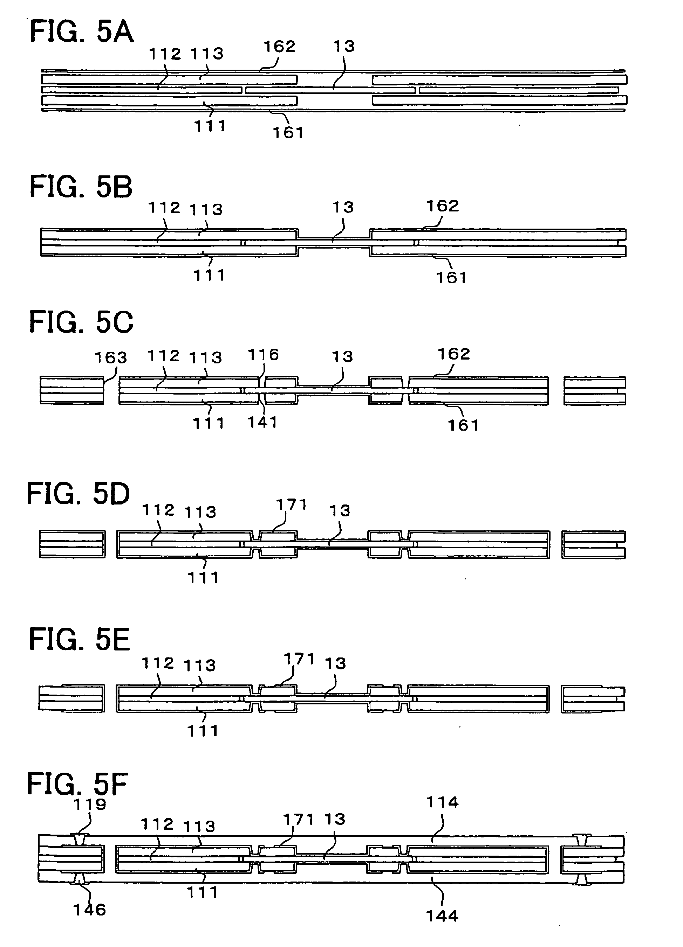

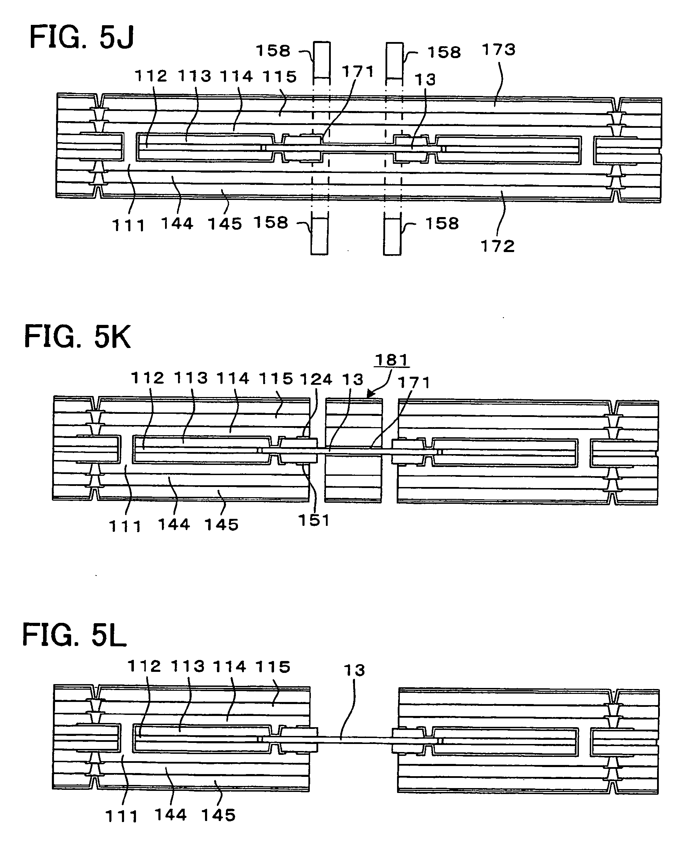

First, as shown in Fig. 5A, the first insulating layer 111, the non-flexible base material 112, and the second insulating layer 113, which form the core of the rigid substrate 11, are positioned at predetermined places. In this case, the first and the second insulating layers 111 and 113 are formed, for example, of low flow prepregs containing inorganic materials 111a, 111b, 113a, and 113b, and having a thickness of 20 to 50 µm, and the non-flexible base material 112 is formed, for example, of a glass epoxy base material having a thickness of approximately 100 µm. The low flow prepregs as described above are formed, for example, by impregnating the glass clothes 111a and 113a, which are an inorganic material, with an epoxy resin added with the inorganic materials 11b and 113b, such as silica filler or glass filler, or by thermal-curing of an epoxy resin added with the inorganic materials 11b and 113b, such as the silica filler or the glass filler, beforehand to increase the curing degree.

In this embodiment, as shown in Fig. 2, the thickness of the non-flexible base material 112 and the thickness of the flexible substrate 13 are preferably approximately equivalent to each other. According to the structure described above, in a space present between the non-flexible base material 112 and the cover lay 139, the resin 125 containing the inorganic materials 111b and 113b can be filled, and the flexible substrate 13 and the non-flexible base material 112 can be surely adhered to each other.

In addition, since the resin 125 filled in the space is integrally cured with the insulating layer 113, the periphery of the via 116 is fixed by the resin 125, and hence the connection reliability between the via 116 and the conductive layer 133 is improved.

In the same manner as described above, a non-flexible base material and a first and a second insulating layer, which form a core of the rigid substrate 12, are positioned at predetermined places.

Furthermore, one end portion of the flexible substrate 13 is sandwiched between the first and the second insulating layers 111 and 113 of the rigid substrate 11 for positioning, and the other end portion is disposed between the non-flexible base material and the first and the second insulating layers of the rigid substrate 12. Furthermore, conductive films 161 and 162 made of copper or the like are disposed on the top and the bottom of a body thus formed.

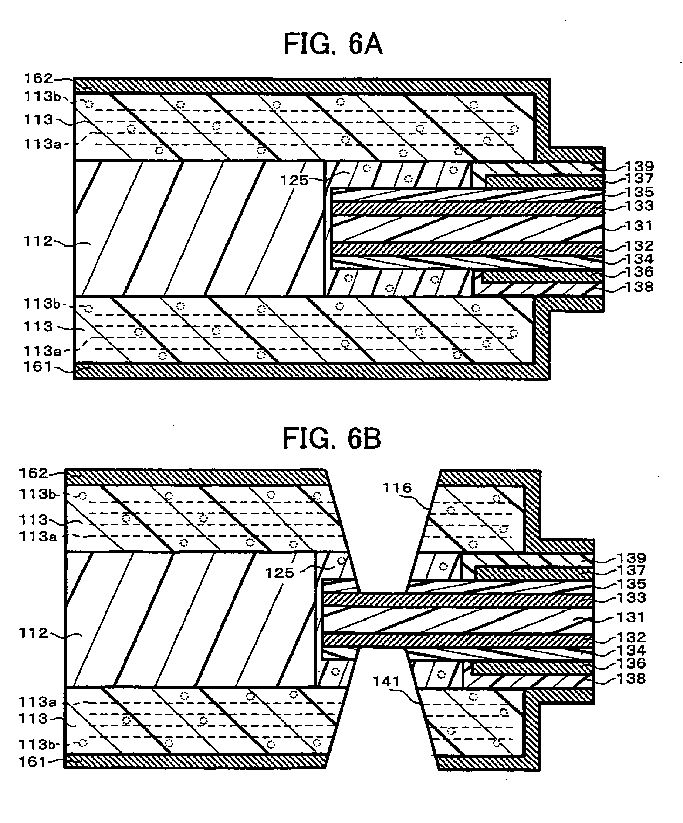

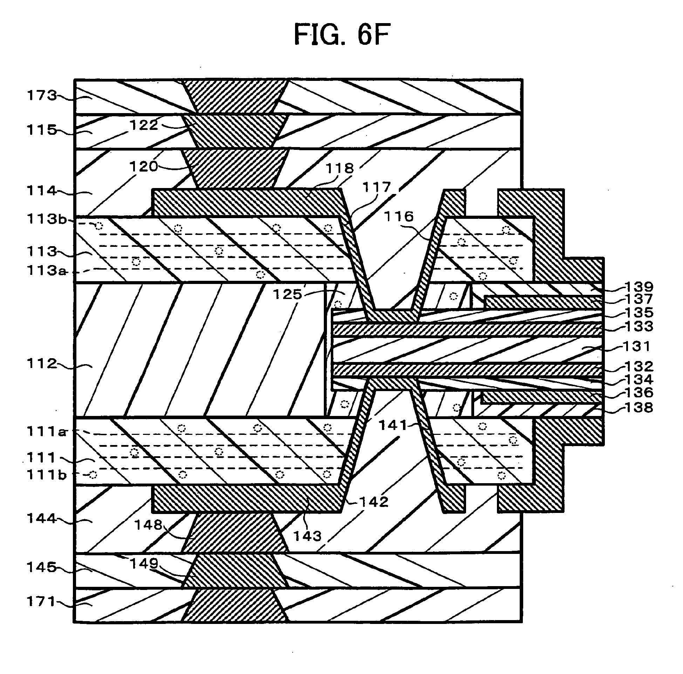

Next, as shown in Fig. 5B, the above body is processed by pressure compression. In this step, as shown by an enlarged view of Fig. 6A, the resin 125 containing the inorganic materials 111b and 113b, which is pushed out of the prepregs forming the first and the second insulating layers 111 and 113, fills the space between the non-flexible base material 112 and the flexible substrate 13. As described above, since the space is filled with the resin 125, the flexible substrate 13 and the non-flexible base material 112 can be reliably adhered to each other.

The above pressure compression is performed, for example, by a hydraulic press machine under conditions in which the temperature, the pressure, and the press time are set to approximately 200°C, 40 kgf, and 3 hours, respectively.

Subsequently, for example, by heating the whole, the prepregs forming the first and the second insulating layers 111 and 113 and the resin 125 are cured and are integrated together. In this step, the cover lays 138 and 139 of the flexible substrate 13 and the resin of the first and the second insulating layers 111 and 113 are polymerized. When the resin of the insulating layers 111 and 113 is polymerized, the periphery of the via 116 is fixed by the resin, and the connection reliability between the via 116 and the conductive layer 133 is improved.

Next, for example, by irradiation of CO₂ laser from a CO₂ laser machining device, IVH (Interstitial Via Hole) 163 is formed whenever necessary as shown in Fig. 5C. In this case, as shown by an enlarged view of Fig. 6B, the vias 116 and 141 are also formed to connect the conductive layers 132 and 133 of the flexible substrate 13 to the rigid substrates 11 and 12.

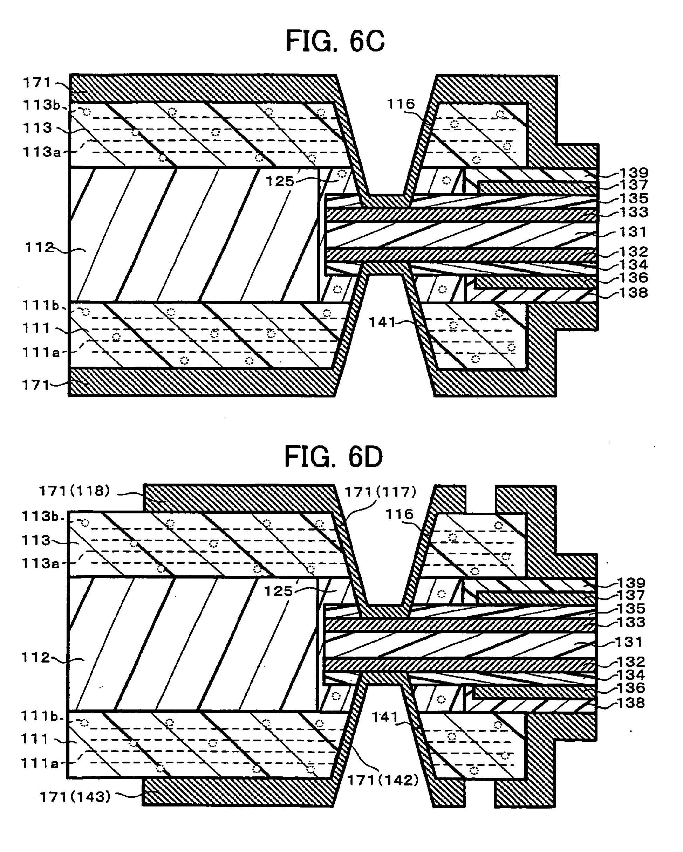

Subsequently, as shown in Fig. 5D, the entire surface of the structure is processed by copper plating. This copper plating and the existing copper patterns 161 and 162 are integrated together, and hence a copper film 171 is formed over the entire surface of the substrate. As shown in Fig. 6C, the copper film 171 is also formed inside the vias 116 and 141. In this step, the flexible substrate 13 is covered with the copper foils 161 and 162 and hence is not directly brought into contact with a plating solution. Hence, the flexible substrate 13 is not damaged by a plating solution at all.

Subsequently, as shown in Fig. 5E, the copper film 171 located at the substrate surface is patterned. By this step, the wire patterns 117 and 142 connected to the conductive layers 132 and 133 of the flexible substrate 13 and the lead patterns 118 and 143 are formed. In this step, as shown in Fig. 6D, the copper foil 171 is allowed to remain at the front portions of the first and the second insulating layers 111 and 113.

Next, as shown in Fig. 5F, on the top and the bottom of a body thus obtained, the first and the third upper insulating layers 114 and 144 are disposed. The first and the third upper insulating layers 114 and 144 are formed, for example, of prepregs made of glass clothes, which are an inorganic material, impregnated with a resin containing an inorganic material such as silica filler or glass filler. The vias 116 and 141 are filled with the resin forming the prepregs.

Subsequently, for example, by curing the resin of the prepregs and inside the vias by heating, the first and the third upper insulating layers 114 and 144 are solidified. Then, vias 119 and 144 are formed in the first and the third upper insulating layers 114 and 144, and by copper plating or the like, the vias 119 and 144 are filled with a conductive material. Alternatively, a conductive paste (such as a thermosetting resin containing conductive particles) may be filled in the vias 119 and 114 by screen printing or the like, followed by curing.

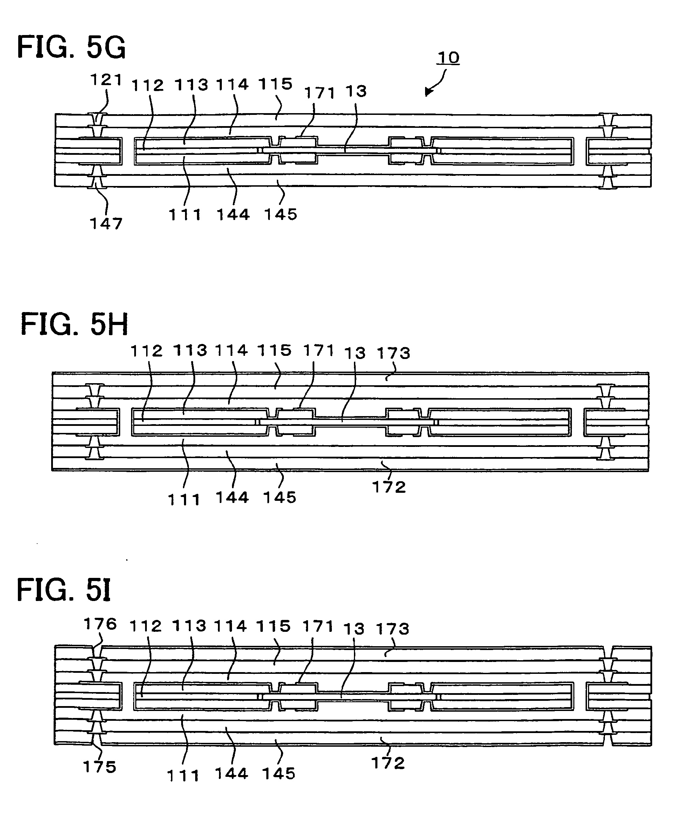

Next, as shown in Fig. 5G, on the top and the bottom of the entire substrate, the second and the fourth upper insulating layers 115 and 145 are disposed. The second and the fourth upper insulating layers 115 and 145 are formed, for example, of general prepregs made of glass clothes, which are an inorganic material, impregnated with a resin containing an inorganic material such as silica filler or glass filler.

Subsequently, for example, by curing the resin of the prepregs by heating, the second and the fourth upper insulating layers 115 and 145 are solidified.

Furthermore, vias 121 and 147 are formed in the second and the fourth upper insulating layers 115 and 145, and by copper plating or the like, the vias 121 and 147 are filled with a conductive material. Alternatively, a conductive paste (such as a thermosetting resin containing conductive particles) may be filled in the vias 121 and 147 by screen printing or the like, followed by curing. When the same conductive paste material is filled in the vias 121 and 147, the connection reliability can be improved when a thermal stress is applied to the vias 121 and 147.

Furthermore, whenever necessary, as shown in Fig. 5H, resin copper foil sheets (Resin Cupper Film; RCF) 172 and 173 are disposed as the outermost layers of the substrate, followed by compression.

Subsequently, the entire substrate is heated, so that the resin is cured.

Then, as shown in Fig. 5I, vias 174 and 175 are formed in the RCF 172 and 173. Next, by copper plating or the like, the vias 174 and 175 are filled with a conductive material. In addition, whenever necessary, the copper foil located at the surface is patterned to form a conductive pattern.

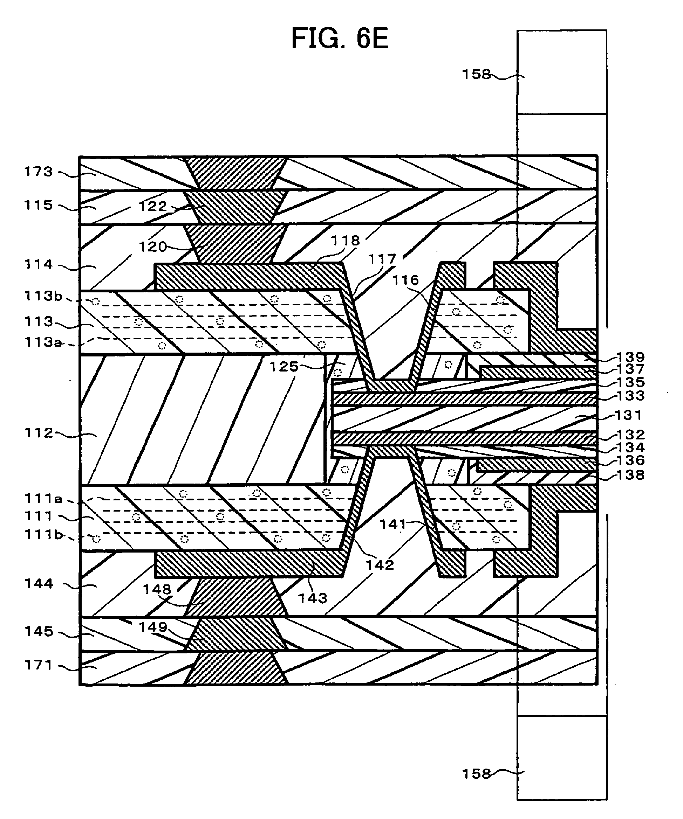

Next, as shown in Figs. 5J and 6E, bonding portions of the flexible substrate 13 with the rigid substrates 11 and 12 are irradiated with laser light 158, such as CO₂ laser, generated from a laser machining device, so that the upper insulating layers 114, 115, 144, and 145, and the resin copper foil sheets (RCF) 172 and 173 are cut off by using the copper foil 171 formed on the front end portions of the cores of the rigid substrates 11 and 12 as a stopper. In this step, the energy or the irradiation time is adjusted so as to cut the copper foil 171 used as the stopper to a certain extent.

Accordingly, as shown in Fig. 5H, a structural body 181 on the flexible substrate 13 is separated from the others.

Next, as shown in Fig. 5L, the structural body 181 is removed as if it is peeled away from the flexible substrate 13. The copper foils 161 and 162 (see Fig. 5B), from which the remaining copper foil 171 is formed, are simply pressed on the cover lays 138 and 139 and are not fixedly bonded thereto. In the same manner as described above, the copper foil 171 is also not fixedly bonded to the flexible substrate 13. Hence, when the structural body 181 is removed, the copper foil 171 is also removed.

As described above, parts of the copper foil 171, which are not covered with other members, are removed. Hence, at the front end portions of the first and the second insulating layers 111 and 113, the copper foils 124 and 151, which are covered with the prepregs 113 and 144, remain.

As described above, the end portions of the flexible substrate 13 are held by the core portions (the first and the second insulating layers 111 and 113) of the rigid substrates 11 and 12, and in addition, lands of the rigid substrates 11 and 12 and connection pads of the flexible substrate are connected to each other by plating, thereby forming the flex-rigid wiring board 10.

According to the structure described above, plating on polyimide of the flexible substrate 13 is not required, and hence the connection reliability can be ensured.

In addition, RCF can be used as the outermost layers of the rigid substrates 11 and 12. Hence, the same reliability and falling impact resistance as those of a conventional rigid substrate can be ensured.

In this manufacturing method, in order to form the core layers of the rigid layers 11 and 12, prepregs made of a resin having low flow properties are required. However, for other than the core layers, general prepregs can be used, IVH filling is not necessary, and voids are also not liable to be generated.

Furthermore, since the bending portion is formed only of the flexible substrate, the stability is improved.

Since openings are formed in a plurality of layers by laser machining after the external layers are formed, the manufacturing cost can be reduced.

In addition, since openings are formed in a plurality of layers by laser machining after the external layers are formed, the accuracy of the opening in the flexible substrate is high.

In addition, since the core portions of the rigid substrates 11 and 12 are formed from a glass epoxy base material, the falling impact resistance can be improved.

The flex-rigid wiring board 10 according to one embodiment of the present invention has been described; however, the present invention is not limited to the above embodiment.

For example, the materials, the sizes, the number of layers described above, and the like may be modified as desired.

For example, in the above embodiment, the resin 125 and the resin forming the first and the second insulating layers 111 and 113, the upper insulating layers 114, 115, 144, and 145 are described as a resin containing an inorganic material. However, the present invention is not limited to that described above, and for example, as a resin forming the upper insulating layers 114, 115, 144, and 145, a resin containing no inorganic materials may be used.

Furthermore, when the first and the second insulating layers 111 and 113 contain the glass clothes 111a and 113a, the resin thereof may not contain an inorganic material.

The materials, forms (clothes, filler, particles, and the like), addition amounts, and contents of the inorganic materials contained in the individual members may be optionally determined in accordance with rigidity, strength, coefficient of thermal expansion, and the like required for the members.

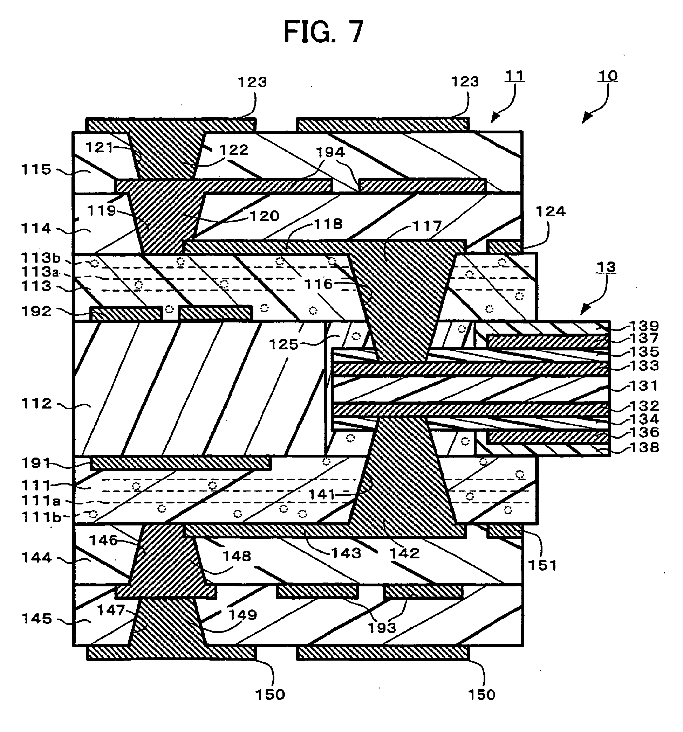

In addition, as shown in Fig. 7 by way of example, the vias 116 and 141 may be filled with a conductive material such as a plating metal. When the vias 116 and 141 are not fully filled with a resin, voids are present inside the vias 116 and 141. In this case, when heat is applied to the flex-rigid wiring board 10, the connection reliability of the vias may be degraded in some cases due to expansion of the voids. As shown in Fig. 7, when the vias 116 and 141 are filled with a plating metal, the connection reliability of the vias 116 and 141 can be improved when heat is applied thereto.

As is the case described above, conductive patterns (circuit patterns) 191 and 192 may be formed on the non-flexible base material 112 to be connected to optional portions.

In addition, conductive patterns (circuit patterns) 193 and 194 may be formed on the first and the third upper insulating layers 114 and 144 to be connected to optional portions.

The conductive patterns 191, 143, 193, and 150 are connected to each other through the vias 146 and 147 and other optional vias. In the same manner as described above, the conductive patterns 192, 118, 194, and 123 are connected to each other through the vias 119 and 121 and other vias. Furthermore, through the via 163, the conductive patterns 123 and 150 are also connected to each other.

In this embodiment, the first and the second insulating layers 111 and 113, which sandwich the end portion of the flexible substrate 13, may be formed from RCF. In addition, the first and the third upper insulating layers 114 and 144 and the second and the fourth upper insulating layers 115 and 145 may be formed of RCF. By the structure as described above, the number of manufacturing steps can be decreased.

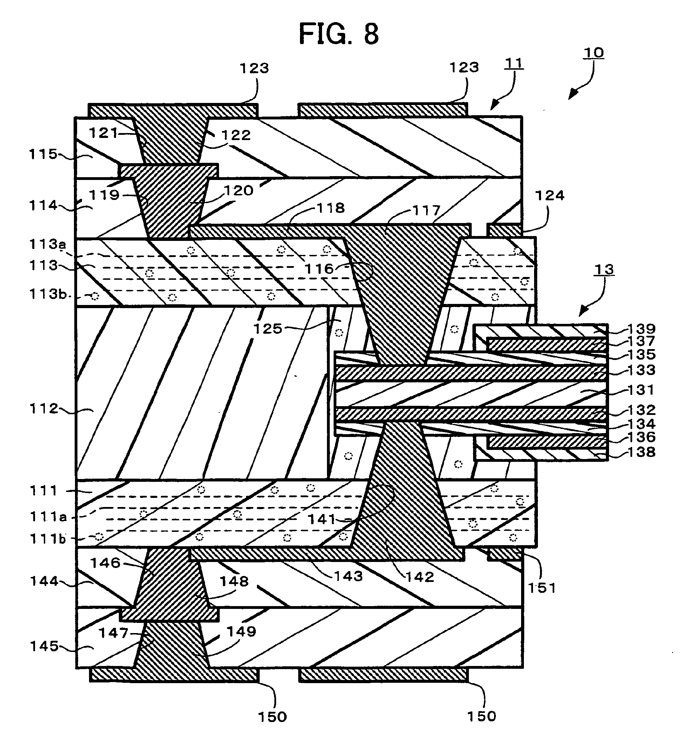

In this embodiment, the thickness of the flexible substrate 13 is set to be approximately equivalent to that of the non-flexible base material 112; however the present invention is not limited to this example. For example, as shown in Fig. 8, the thickness of the flexible substrate 13 may be formed smaller than that of the non-flexible base material 112. In this case, a space formed between the flexible substrate 13, the non-flexible base material 112, and the first and the second insulating layers 111 and 113 is filled with an optional resin, such as a resin which oozes from the insulating layers 111 and 113 or a resin which is provided beforehand in manufacturing for height adjustment. Since the space is filled with the resin 125, the flexible substrate 13 and the non-flexible base material 112 can be surely adhered to each other.

In addition, those resins are integrally cured and solidified together by heating in manufacturing. As described above, since the resins of the insulating layers 111 and 113 are polymerized, and the resin 125 is further integrally cured and solidified, the peripheries of the vias 116 and 141 are fixed by the resins, and hence the connection reliability of the vias 116 and 141 with the conductive layer 133 and 132 are improved.

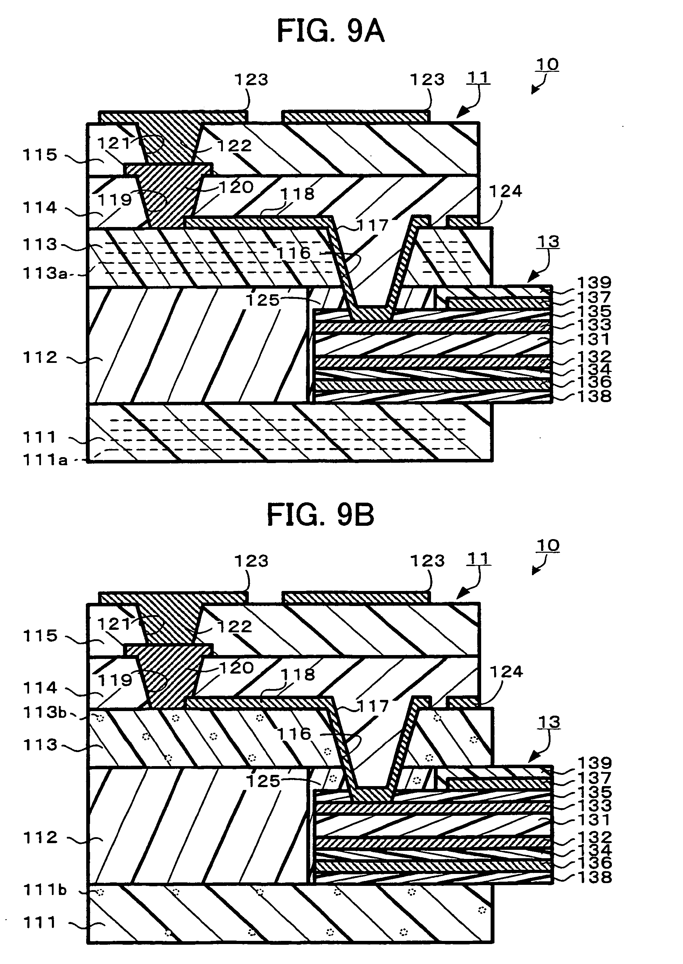

In the embodiment described above, the first insulating layer 111 contains the glass clothes 111a and the inorganic material 111b, and the second insulating layer 113 contains the glass clothes 113a and the inorganic material 113b. However, as for the flex-rigid wiring board 10 shown in Fig. 2, for example, the structure may be formed as shown in Fig. 9A in which the first and the second insulating layers 111 and 113 contain the glass clothes 111a and 113a and contain no inorganic materials 111b and 113b. In addition, as shown in Fig. 9B, the structure may also be formed in which the first and the second insulating layers 111 and 113 contain the inorganic materials 111b and 113b but contain no glass clothes 111a and 113a.

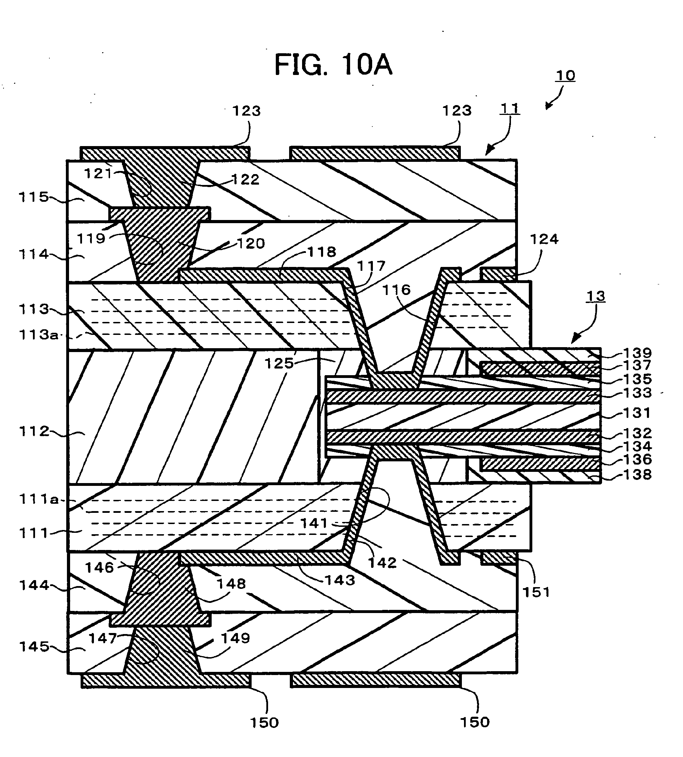

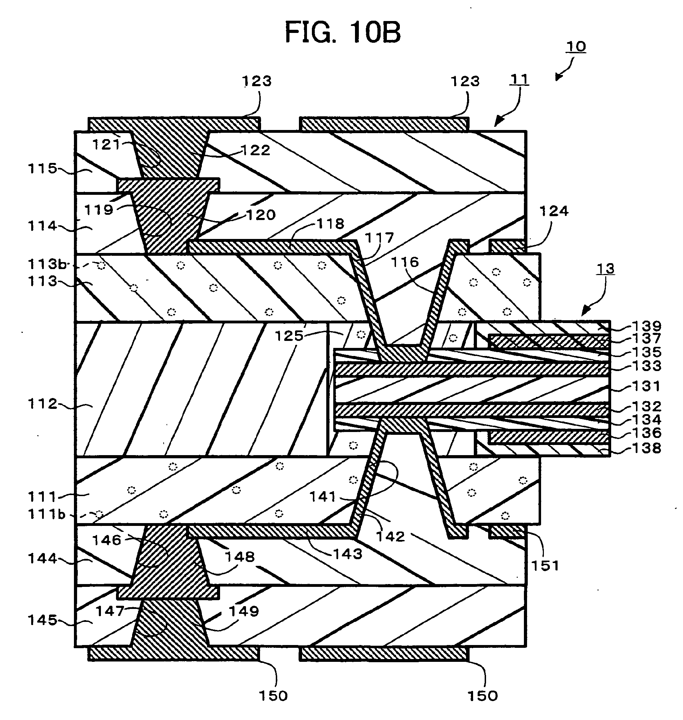

Furthermore, as for the flex-rigid wiring board 10 shown in Fig. 3, for example, as shown in Fig. 10A, the first and the second insulating layers 111 and 113 may contain the glass clothes 111a and 113a, respectively, but may not contain the inorganic materials 111b and 113b. In addition, as shown in Fig. 10B, the first and the second insulating layers 111 and 113 may contain the inorganic materials 111b and 113b, respectively, but may not contain the glass clothes 111a and 113a.

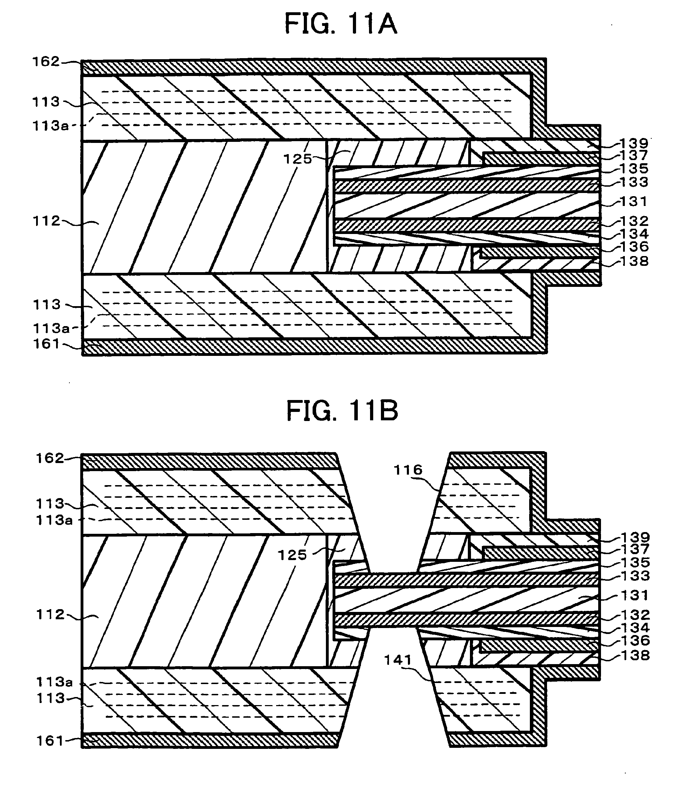

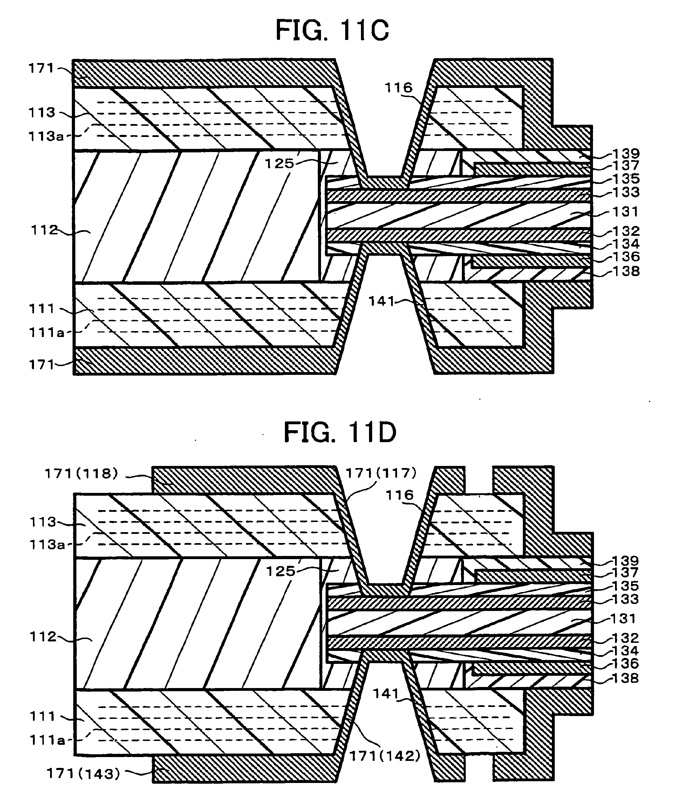

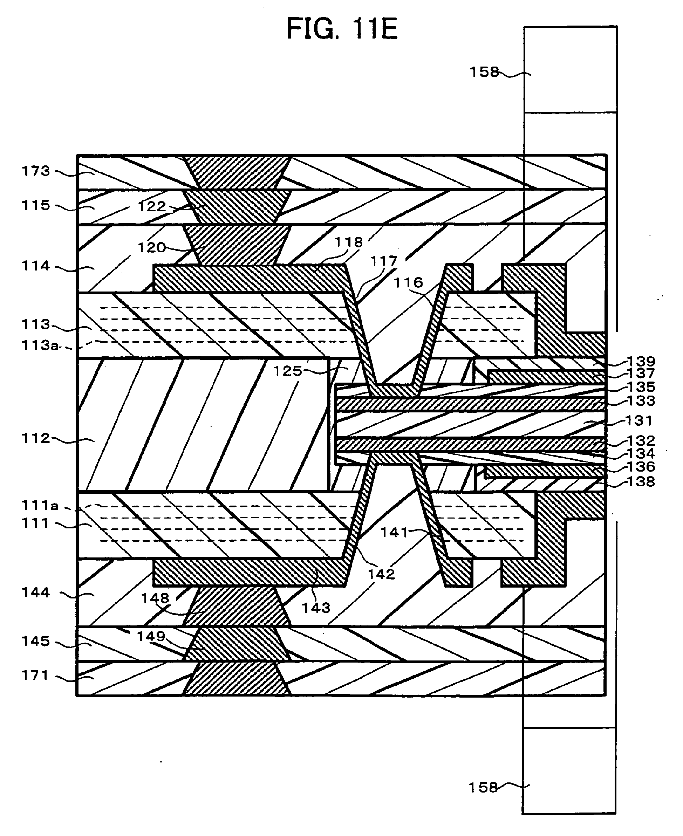

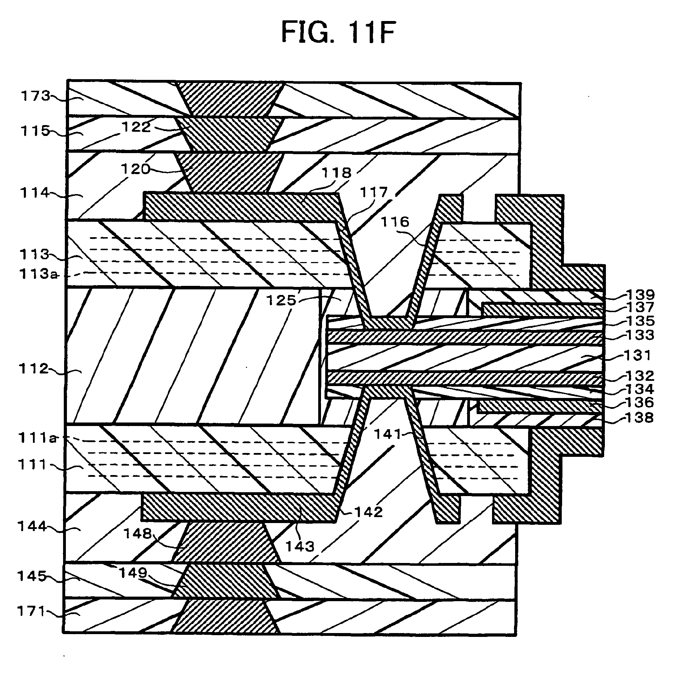

The flex-rigid wiring board 10 having the structure shown in Fig. 10A is manufactured, for example, by the steps shown in Figs. 5A to 5L and 11A to 11F. This manufacturing method is the same as that described with reference to Figs. 5A to 5L and 6A to 6F except that as the first and the second insulating layers 111 and 113, insulating layers (prepregs) which contain the glass clothes 111a and 113a but contain no inorganic materials 111b and 113b are used.

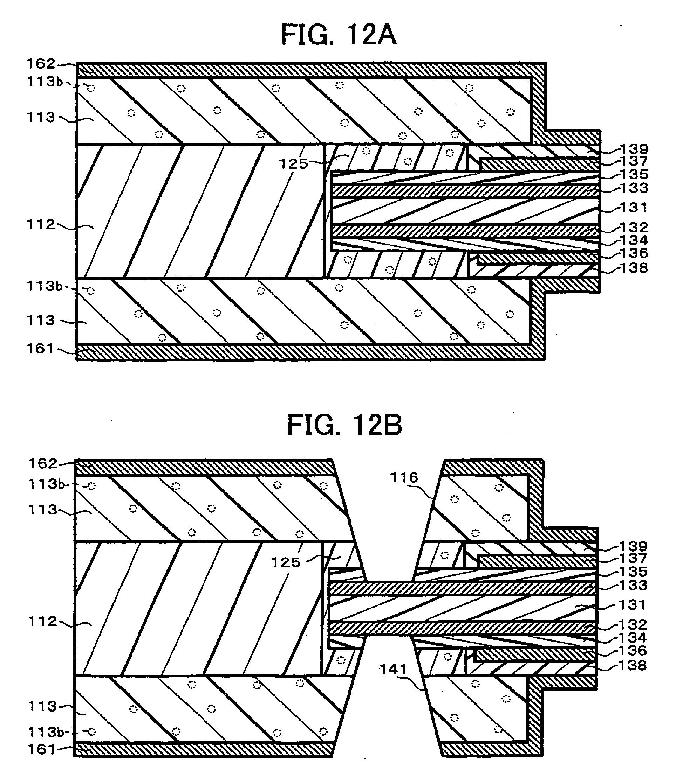

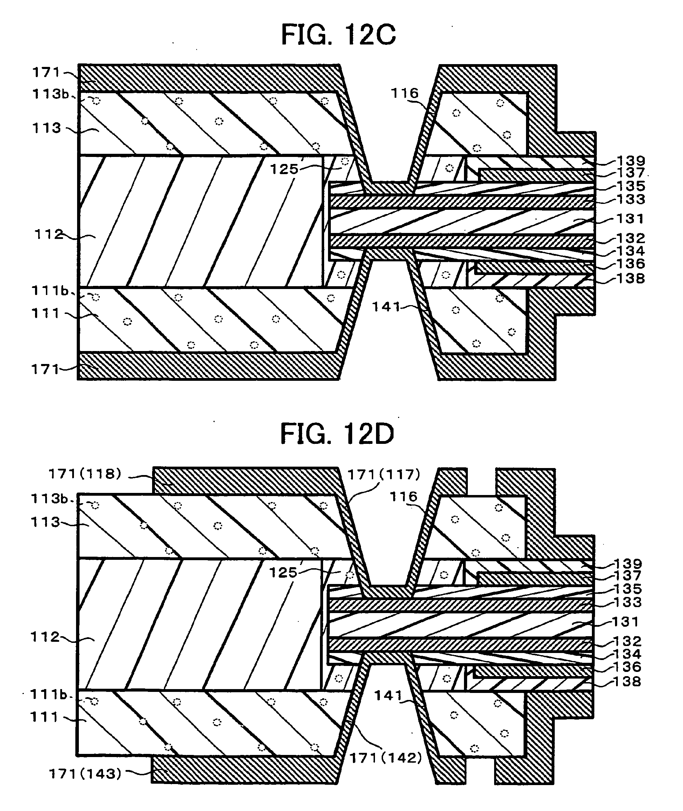

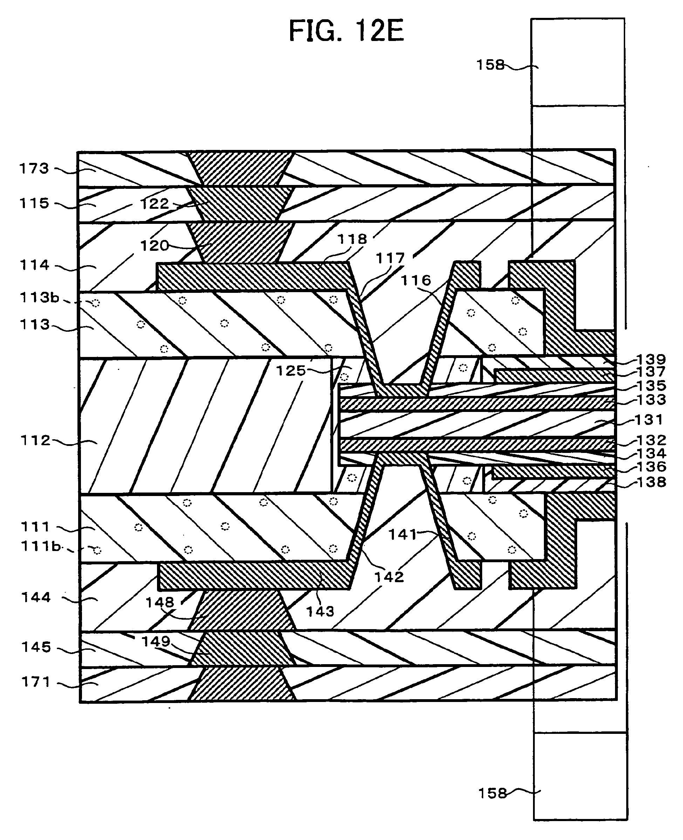

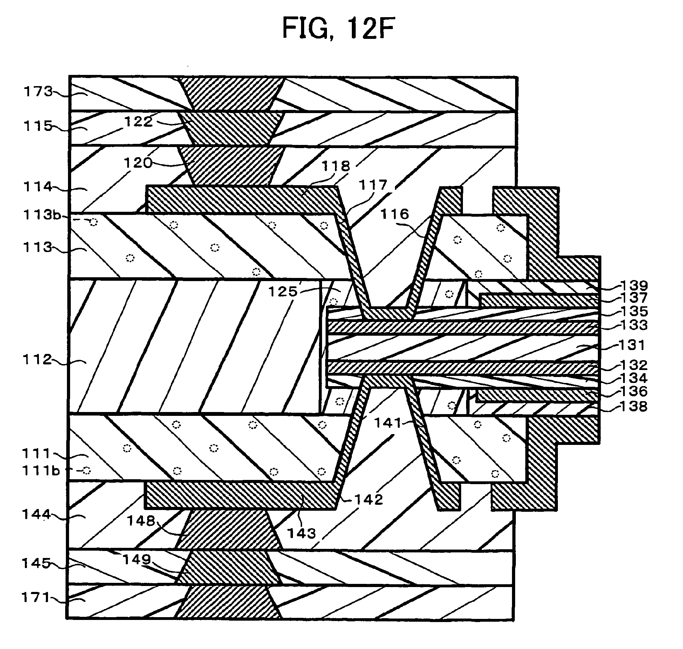

In addition, the flex-rigid wiring board 10 having the structure shown in Fig. 10B is manufactured, for example, by the steps shown in Figs. 5A to 5L and 12A to 12F. This manufacturing method is the same as that described with reference to Figs. 5A to 5L and 6A to 6F except that as the first and the second insulating layers 111 and 113, insulating layers (prepregs) which contain no glass clothes 111a and 113a but contain the inorganic materials 111b and 113b are used.

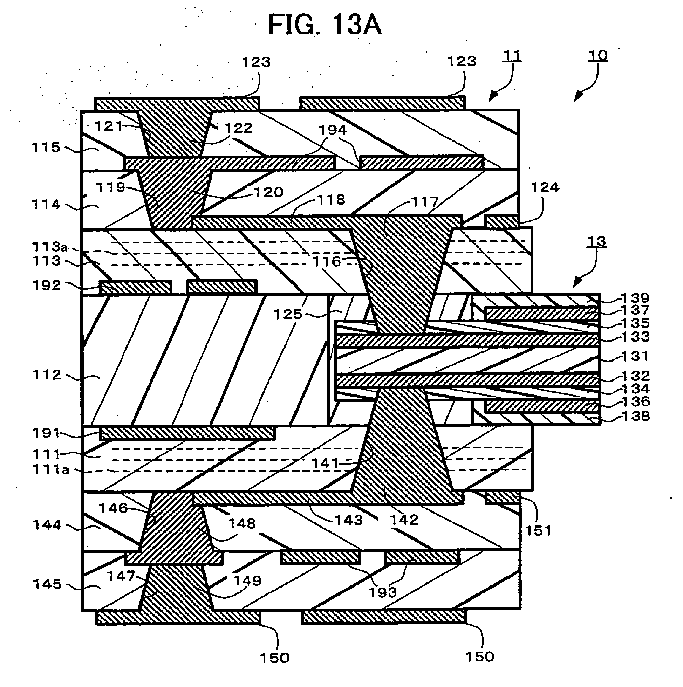

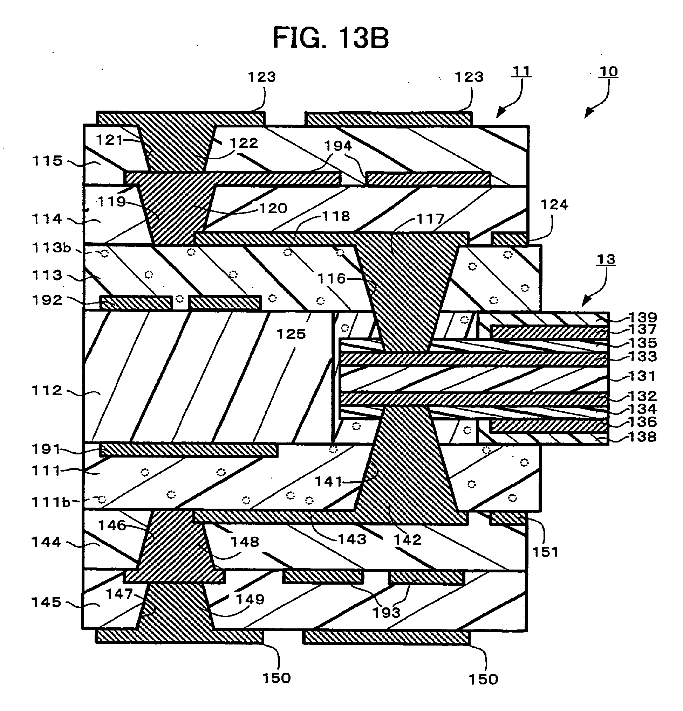

Furthermore, the flex-rigid wiring board 10 shown in Fig. 7 may be formed, for example, from the first and the second insulating layers 111 and 113 which contain the glass clothes 111a and 113a but contain no inorganic materials 111b and 113b as shown in Fig. 13A. In addition, as shown in Fig. 13B, the first and the second insulating layers 111 and 113 may contain the inorganic materials 111b and 113b, respectively, but may not contain the glass clothes 111a and 113a.

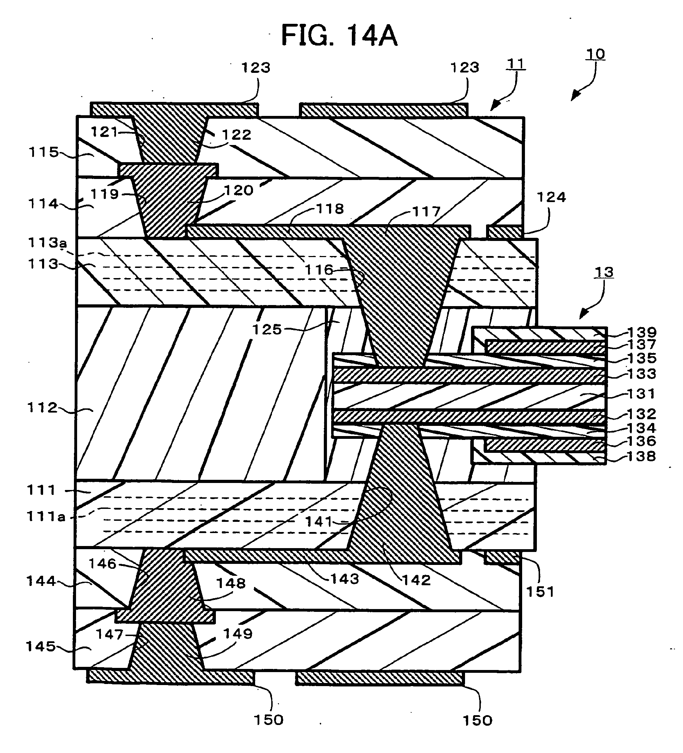

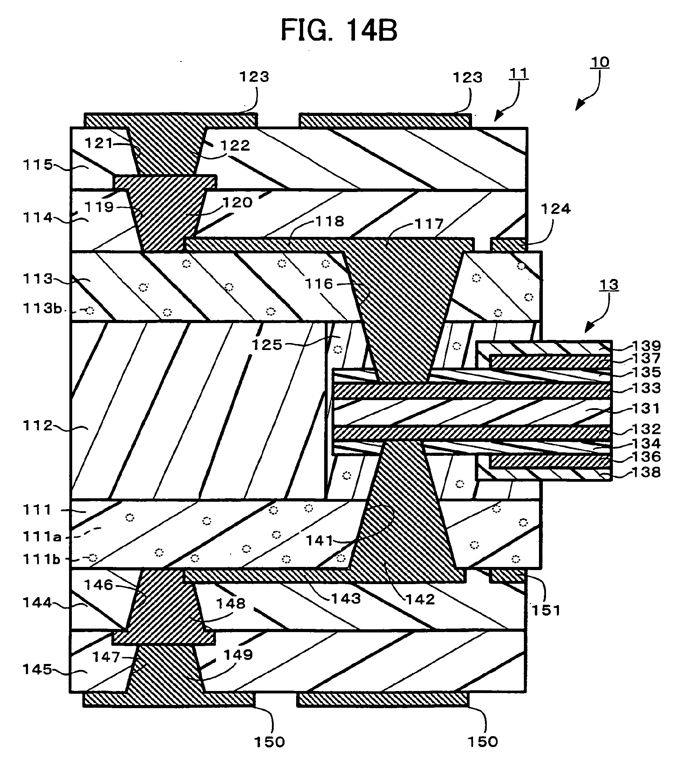

Furthermore, the flex-rigid wiring board 10 shown in Fig. 8 may be formed, for example, from the first and the second insulating layers 111 and 113 which contain the glass clothes 111a and 113a but contain no inorganic materials 111b and 113b, as shown in Fig. 14A. In addition, as shown in Fig. 14B, the first and the second insulating layers 111 and 113 may contain the inorganic materials 111b and 113b, respectively, but may not contain the glass clothes 111a and 113a.

In the embodiments described above, as the inorganic materials contained in the insulating layers 111 and 113, the glass clothes 111a and 113a, and the silica filler or the glass filler 111b and 113b are described by way of example. The insulating layers 111 and 113 may contain an inorganic material other than those described above. For example, the insulating layers 111 and 113 may contain silica particles, glass particles, carbon fibers, ceramic fibers, and the like.

Furthermore, the upper insulating layers 114, 115, 144, and 145 also preferably contain inorganic materials such as glass clothes, silica filler, glass filler, and the like.

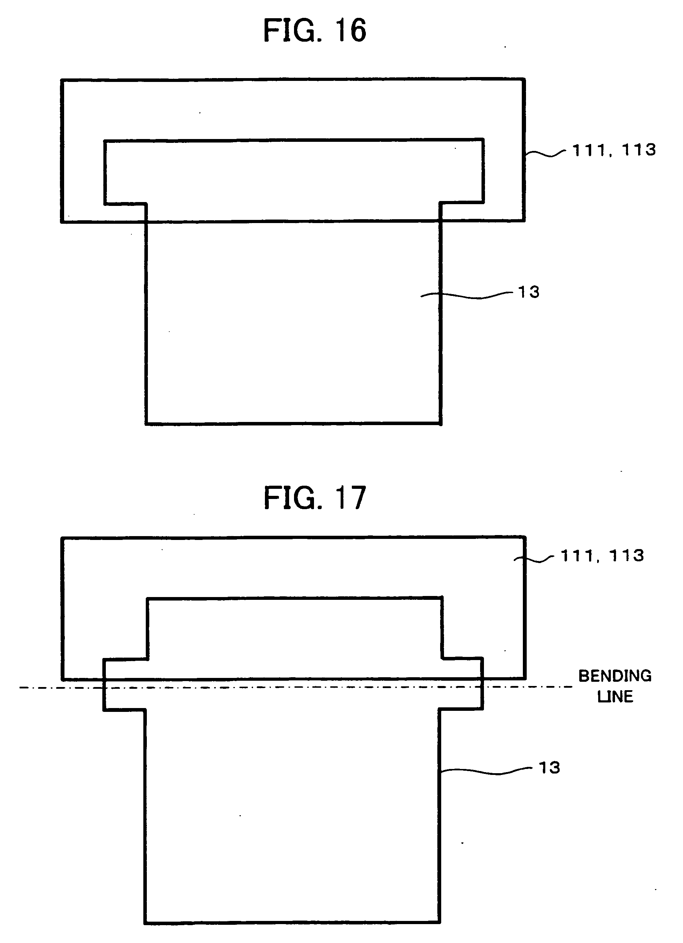

In addition, the wire patterns formed on the rigid substrates 11 and 12 and the flexible substrate 13 are not limited to those shown in Fig. 1, and as shown in Fig. 17 by way of example, a wire pattern may be formed so as to be fanned out from the flexible substrate 13 to the rigid substrates 11 or 12. That is, the pitch of the connection portion 13b may be set larger than the pitch of the wire 13a of the flexible substrate 13. Accordingly, a larger number of wires may be disposed on the flexible substrate 13, and as a result, a flex-rigid wiring board having a high wire density can be formed.

In addition, in order to increase the strength of boundary portions of the flexible substrate 13 with the rigid substrates 11 and 12, as shown in Figs. 18 and 19 by way of example, it is effective that the flexible substrate 13 be formed to partly have a larger width. Accordingly, the bonding areas of the flexible substrate 13 to the rigid substrates 11 and 12 are increased, and as a result, the connection reliability of the vias can be improved.

For example, in the example shown in Fig. 18, the end portion of the flexible substrate 13 is increased, so that the areas of parts thereof fixed to the rigid substrates 11 and 12 are increased. Accordingly, the strength of the end portions of the flexible substrate 13 is increased, and hence the bending resistance can be improved.

In addition, in the example shown in Fig. 19, protrusions are formed at positions at which the flexible substrate 13 is bent repeatedly (for example, positions which correspond to the end portions of the rigid substrates 11 and 12), so that the strength at the positions at which bending is repeatedly performed is increased.

### Industrial Applicability

This invention is applicable to a flex-rigid wiring board, a part of which includes a non-flexible base material, and the other part of which includes a flexible base material.

## Claims

1. A flex-rigid wiring board comprising:
a flexible base material (131) provided with a conductive pattern (133, 132) having a connection pad (13b);
a non-flexible base material (112) disposed adjacent to the flexible base material (131) in a horizontal direction;
insulating layers (111, 113) each containing an inorganic material (111a, 111b, 113a, 113b), which cover the non-flexible base material (112) and the flexible base material (131), and which expose at least a part of the flexible base material (131); and
a conductive pattern (143, 118) formed on the insulating layers (111, 112),
**characterised in that** the conductive pattern (132, 133) of the flexible base material (131) and the conductive pattern (143, 118) on the insulating layers (111, 113) are connected to each other by plating (142, 117) onto the connection pad (136) formed on the flexible base material without penetrating the connection pad.

2. The flex-rigid wiring board according to Claim 1,
wherein the flexible base material (131) and the non-flexible base material (112) are disposed with a space provided therebetween, and
the space is filled with a resin (125) containing an inorganic material.

3. The flex-rigid wiring board according to Claim 1,
wherein the flexible base material (131) and the non-flexible base material (112) are disposed with a space provided therebetween,
the space is filled with a resin (125) containing an inorganic material, and
the resin (125) is cured integrally with the insulating layers (111, 113).

4. The flex-rigid wiring board according to Claim 1,
wherein a conductive pattern (191, 192) is formed on a surface of the non-flexible base material (131).

5. The flex-rigid wiring board according to Claim 1,
wherein the insulating layers (111, 113) cover a boundary region between an end portion of the flexible base material (131) and an end portion of the non-flexible base material (112) from a front surface side and a rear surface side.

6. The flex-rigid wiring board according to Claim 1,
wherein the insulating layers (111, 113) cover a boundary region between an end portion of the flexible base material (131) and an end portion of the non-flexible base material (112) from a front surface side and a rear surface side,
the insulating layers have a via (141, 116)), and
the conductive pattern (143, 118) on the insulating layers (111, 113) is connected to the conductive pattern (132, 133) of the flexible base material (131) through the via (141, 116).

7. The flex-rigid wiring board according to Claim 1, further comprising:
an upper insulating layer (144, 145, 114, 115) formed on the insulating layers (111, 113); and
an upper conductive pattern (150, 123, 193, 194) formed on the upper insulating layer (144, 145, 114, 115),
wherein the conductive pattern (150, 123, 193, 194) on the insulating layers (111, 113) and the upper conductive pattern (150, 123, 193, 194) are connected to each other through an upper via (146, 147, 119, 121) filled with a plating metal (148, 149, 120, 122), and
the upper insulating layer (144, 145, 114, 115) is composed of a resin layer processed by a curing treatment and contains an inorganic material.

8. The flex-rigid wiring board according to Claim 1, further comprising:
a first upper insulating layer (144, 114) formed on the insulating layers (111, 113);
a first upper conductive pattern formed on the first upper insulating layer (111, 113);
a second upper insulating layer (145, 115) formed on the first upper conductive pattern (193, 194); and
a second upper conductive pattern (150, 123) formed on the second upper insulating layer (145, 115),
wherein the conductive pattern (143, 118) on the insulating layers (111, 113) and the first upper conductive pattern (193, 194) are connected to each other through a first upper via (146, 119) filled with a plating metal 148, 120), and
the second upper insulating layer (145, 115) has a second upper via (147, 121) which is located approximately over the first upper via (146, 119), which connects the first upper conductive pattern (193, 194) and the second upper conductive pattern (150, 123), and which is filled with a plating metal (149, 122).

9. The flex-rigid wiring board according to Claim 1,
wherein an upper insulating layer (144, 114, 145, 115) is formed on the insulating layers (111, 113),
an upper via (146, 119, 147, 121) is formed in the upper insulating layer (144, 114, 145, 115) and is connected to the conductive pattern (143, 118) on the insulating layers (111, 113), and
a conductive pattern (150, 123, 193, 194) connected to the upper via (146, 119, 147, 121) is formed on the upper insulating layer (144, 114, 145, 115).

10. The flex-rigid wiring board according to Claim 9,
wherein the upper insulating layer (144, 114, 145, 115) includes a glass cloth.

11. The flex-rigid wiring board according to Claim 1,
wherein a resin copper foil sheet (114, 115) is laminated on the insulating layers (111, 113), and
a resin of the resin copper foil sheet (114, 115) is processed by a curing treatment.

12. The flex-rigid wiring board according to Claim 1,
wherein a via (141, 116) is formed in the insulating layers (111, 113), and
the conductive pattern (143, 118) on the insulating layers (111, 113) is connected to the conductive pattern (132, 133) of the flexible base material (131) through the via (141, 116).

13. The flex-rigid wiring board according to Claim 12,
wherein an upper insulating layer (144, 145, 114, 115) containing an inorganic material is formed on the insulating layers (111, 113),
an upper conductive pattern (150, 123, 193, 194) is formed on the upper insulating layer (144, 145, 114, 115),
the conductive pattern (143, 118) on the insulating layers (111, 113) and the upper conductive pattern (150, 123, 193, 194) are connected to each other through an upper via (146, 119, 147, 121) which is formed in the upper insulating layer (144, 145, 114, 115) and which is filled with a plating metal (148, 149, 120, 122).

14. The flex-rigid wiring board according to Claim 12,
wherein a resin layer (144, 114) containing a resin is disposed on the insulating layers, and
the resin of the resin layer is filled in the via (141, 116).

15. The flex-rigid wiring board according to Claim 12,
wherein the via is filled with a metal.

16. The flex-rigid wiring board according to Claim 12,
wherein the via (141, 116) penetrates at least one of the insulating layers (111, 113) and is filled with a plating metal (142, 117),
an upper insulating layer (144, 114, 145, 115) containing an inorganic material and an upper conductive pattern (150, 123, 193, 194) are laminated on the insulating layers (111, 113),
an upper via (146, 147, 119, 121) connecting the conductive pattern on the insulating layers (111, 113) and the upper conductive pattern is formed in the upper insulating layer (144, 114, 145, 115), and
the upper via (146, 147, 119, 121) is connected to the via filled with the plating metal.

17. The flex-rigid wiring board according to Claim 12,
wherein the conductive pattern (151, 124) on the insulating layers extends over a boundary region between the flexible base material and the non-flexible base material and reaches a place corresponding to end portions of the insulating layers.

18. The flex-rigid wiring board according to Claim 12,
wherein a planar conductive layer (151, 124) is formed on the insulating layers at an end portion at the flexible base material side.

19. The flex-rigid wiring board according to Claim 12,
wherein the flexible base material has connection pads (13b) to be connected to the vias,
the pitch of the connection pads is larger than the pitch of the conductive patterns (13a) formed on the flexible base material, and
the conductive patterns are formed to increase the pitch thereof toward the connection pads and are electrically connected to the respective connection pads.

20. The flex-rigid wiring board according to Claim 12,
wherein an upper insulating layer (144, 145, 114, 115) containing an inorganic material is formed on the insulating layers, and
an upper conductive pattern (150, 123, 193, 194) is formed on the upper insulating layer,
the conductive pattern on the insulating layers and the upper conductive pattern are connected to each other through an upper via formed in the upper insulating layer, and
end surfaces of the insulating layers at the flexible base material side protrude than an end surface of the upper insulating layer at the flexible base material side.

21. The flex-rigid wiring board according to Claim 12,
wherein an upper insulating layer (144, 145, 114, 115) containing an inorganic material is formed on the insulating layers,
an upper conductive pattern (150, 123, 193, 194) is formed on the upper insulating layer,
the conductive pattern on the insulating layers and the upper conductive pattern are connected to each other through an upper via (146, 147, 119, 121) formed in the upper insulating layer, and
the upper via is filled with a cured product of a conductive paste.

22. The flex-rigid wiring board according to Claim 1, wherein
the flexible base material (131) is provided with a protective layer (138, 139) covering the conductive pattern;
wherein the conductive pattern of the flexible base material and the conductive pattern on the insulating layers are connected to each other through a via (141, 116) formed in the insulating layers.

23. The flex-rigid wiring board according to Claim 22,
wherein the via provided in the insulating layers penetrates the protective layer.

24. The flex-rigid wiring board according to Claim 22,
wherein the conductive pattern formed on the insulating layers and the conductive pattern of the flexible base material are connected to each other with the via which is formed in the insulating layers and which penetrates the protective layer.

25. The flex-rigid wiring board according to Claim 22,
wherein an insulating layer (134, 135) is formed between the conductive pattern and the protective layer,
the via (141, 116) is formed to penetrate the insulating layer,
the protective layer is provided in a region in which the via is not formed, and
a space between the non-flexible base material and the protective layer and around the periphery of the via is filled with a resin (125).

26. The flex-rigid wiring board according to Claim 22,
wherein the protective layer (138, 139) is provided in a region in which the via is not formed,
the thickness of the flexible base material including the protective layer is smaller than the thickness of the non-flexible base material,
a space between the protective layer and the insulating layers and around the peripheral portion of the via is filled with a resin (125) which contains an inorganic material, and
the resin is integrally cured with the insulating layers.

27. The flex-rigid wiring board according to Claim 22,
wherein the flexible base material is provided with the conductive pattern and said at least one protective layer covering the conductive pattern, the thickness of the flexible base material including the protective layer being approximately equivalent to that of the non-flexible base material,
the protective layer is provided in a region in which the via is not formed, and
a space between the non-flexible base material and the protective layer and around the periphery of the via is filled with a resin (125) containing an inorganic material.

28. The flex-rigid wiring board according to Claim 22,
wherein the flexible base material is provided with the conductive pattern and the protective layer covering the conductive pattern,
the thickness of the flexible base material including the protective layer is approximately equivalent to that of the non-flexible base material,
the protective layer is provided in a region in which the via is not formed,
a space between the non-flexible base material and the protective layer and around the periphery of the via is filled with a resin (125) containing an inorganic material, and
the resin is integrally cured with the insulating layers.

29. The flex-rigid wiring board according to Claim 22,
wherein the flexible base material is formed to have a thickness smaller than that of the non-flexible base material.

30. The flex-rigid wiring board according to Claim 22,
wherein in the flexible base material, a portion where the flexible base material and the insulating layer are facing with each other and the resins of the flexible base material and the insulating layer are polymerized is wider than a portion where the resins are not polymerized with the insulating layer.

31. The flex-rigid wiring board according to Claim 22,
wherein the width of the flexible base material in a boundary region with the insulating layers is larger than the width of the other part of the flexible base material.

32. The flex-rigid wiring board according to Claim 22,
wherein the protective layer includes an insulating film (134, 135), and
a via formed in the insulating layers (111, 113) penetrates the insulating film (134, 135) and electrically connects the conductive pattern (143, 118) on the insulating layers (111, 113) and the conductive pattern (132, 133) formed for the flexible base material (131).

33. The flex-rigid wiring board according to Claim 22,
wherein the protective layer (138, 139) of the flexible base material (131) includes an electromagnetic shield layer (136, 137).

34. The flex-rigid wiring board according to Claim 22,
wherein the conductive pattern (132, 133) is formed for the flexible base material (131), an insulating film (134, 135) is formed on the conductive pattern (132, 133), and an electromagnetic shield layer (136, 137) is formed on the insulating film (134, 135).

35. The flex-rigid wiring board according to Claim 22,
wherein the conductive pattern (132, 133) is formed for the flexible base material (131),
an insulating film (134, 135) is formed on the conductive pattern (132, 133),
an electromagnetic shield layer (136, 137) is formed on the insulating film (134, 135), and
the protective layer (138, 139) is formed on the electromagnetic shield layer (136, 137).

36. The flex-rigid wiring board according to Claim 22,
wherein the conductive pattern (132, 133) is formed on the flexible base material (131),
an insulating film (134, 135) is formed on the conductive pattern (132, 133),
an electromagnetic shield layer (136, 137) is formed on the insulating film (134, 135), and
the protective layer (138, 139) is formed on the electromagnetic shield layer (136, 137) and is in contact with the insulating film (134, 135).

37. A method for manufacturing a flex-rigid wiring board, comprising the steps of:
disposing a non-flexible base material (112) and a flexible base material (131) provided with a conductive pattern (132, 133) to be adjacent to each other, the conductive pattern having a connection pad (136);
covering a boundary region between the flexible base material and the non-flexible base material with insulating layers (111, 113) which contain an inorganic material, and which are provided with a conductive pattern (143,118);
forming a via (141, 116) which penetrates the insulating layers and which reaches the conductive pattern of the flexible base material; and
connecting the conductive pattern of the flexible base material and the conductive pattern on the insulating layers through the via by plating (142,117) onto the connection pad (136) formed on the flexible base material without penetrating the connection pad.

38. The method for manufacturing a flex-rigid wiring board, according to Claim 37,
wherein the insulating layers are formed of a resin containing an inorganic material,
the resin containing an inorganic material, which forms the insulating layers, is filled in a space formed among the non-flexible base material, the flexible base material, and the insulating layers, and
the filled resin is integrally cured with the insulating layers.

39. The method for manufacturing a flex-rigid wiring board, according to Claim 37,
wherein the via is filled with a plating metal by the plating.

40. The method for manufacturing a flex-rigid wiring board, according to Claim 37,
wherein a boundary region between the flexible base material and the non-flexible base material is covered with the insulating layers from a front surface side and a rear surface side.

41. The method for manufacturing a flex-rigid wiring board, according to Claim 37,
wherein a metal foil is disposed on the insulating layers and the flexible base material,
a second insulating layer containing an inorganic material is disposed on the metal foil; and
the second insulating layer at a position corresponding to end portions of the insulating layers is cut by laser using the metal foil as a stopper.

42. The method for manufacturing a flex-rigid wiring board, according to Claim 37,
wherein a metal foil is disposed on the insulating layers and the flexible base material,
a second insulating layer containing an inorganic material is disposed on the metal foil;
the second insulating layer at a position corresponding to end portions of the insulating layers is cut by laser using the metal foil as a stopper, and
a remaining part on the flexible base material by cutting using the laser is removed together with the metal foil.

43. The method for manufacturing a flex-rigid wiring board, according to Claim 37,
wherein a metal foil is disposed on the insulating layers and the flexible base material,
a circuit pattern is formed above the insulating layers by patterning the metal foil,
a second insulating layer containing an inorganic material is disposed on the metal foil; and
the second insulating layer at a position corresponding to end portions of the insulating layers is cut by the laser using the metal foil as a stopper.

44. The method for manufacturing a flex-rigid wiring board, according to Claim 37,
wherein a metal foil is disposed on the insulating layers and the flexible base material,
a second insulating layer containing an inorganic material is disposed on the metal foil,
a conductive pattern is formed on the second insulating layer, and
the second insulating layer at a position corresponding to end portions of the insulating layers is cut by the laser using the metal foil as a stopper.

45. The method for manufacturing a flex-rigid wiring board, according to Claim 37,
wherein the second insulating layer is composed of a resin containing an inorganic material, and
the via is filled with the resin of the second insulating layer.

46. The method for manufacturing a flex-rigid wiring board, according to Claim 37,
wherein the insulating layers are composed of a resin containing an inorganic material.

## Patentansprüche

1. Starr-flexible Leiterplatte mit:
einem flexiblen Basismaterial (131), das mit einem Leiterbild (133, 132) mit einem Verbindungsplättchen (13b) versehen ist;
einem nicht-flexiblen Basismaterial (112), das angrenzend an das flexible Basismaterial (131) in einer horizontalen Richtung angeordnet ist;
Isolierschichten (111, 113), die jeweils ein anorganisches Material (111a, 111b, 113a, 113b) aufweisen, die das nicht-flexible Basismaterial (112) und das flexible Basismaterial (131) bedecken und die zumindest einen Teil des flexiblen Basismaterials (131) freiliegen lassen; und
einem Leiterbild (143, 118), das an den Isolierschichten (111, 112) ausgebildet ist,
**dadurch gekennzeichnet, dass** das Leiterbild (132, 133) des flexiblen Basismaterials (131) und das Leiterbild (143, 118) an den Isolierschichten (111, 113) miteinander durch Plattieren (142, 117) auf das Verbindungsplättchen (132) verbunden sind, das an dem flexiblen Basismaterial ausgebildet ist, ohne durch das Verbindungsplättchen hindurchzudringen.

2. Starr-flexible Leiterplatte nach Anspruch 1,
bei der das flexible Basismaterial (131) und das nicht-flexible Basismaterial (112) mit einem dazwischen vorgesehenen Raum angeordnet sind und
der Raum mit einem Harz (125) gefüllt ist, das ein anorganisches Material aufweist.

3. Starr-flexible Leiterplatte nach Anspruch 1,
bei der das flexible Basismaterial (131) und das nicht-flexible Basismaterial (112) mit einem dazwischen vorgesehenen Raum angeordnet sind,
der Raum mit einem Harz (125) gefüllt ist, das ein anorganisches Material aufweist, und
das Harz (125) integriert mit den Isolierschichten (111, 113) gehärtet ist.

4. Starr-flexible Leiterplatte nach Anspruch 1,
bei der ein Leiterbild (191, 192) an einer Oberfläche des nicht-flexiblen Basismaterials (131) ausgebildet ist.

5. Starr-flexible Leiterplatte nach Anspruch 1,
bei der die Isolierschichten (111, 113) einen Grenzbereich zwischen einem Endabschnitt des flexiblen Basismaterials (131) und einem Endabschnitt des nicht-flexiblen Basismaterials (112) von einer Vorderoberflächenseite und einer Rückoberflächenseite bedecken.

6. Starr-flexible Leiterplatte nach Anspruch 1,
bei der die Isolierschichten (111, 113) einen Grenzbereich zwischen einem Endabschnitt des flexiblen Basismaterials (131) und einem Endabschnitt des nicht-flexiblen Basismaterials (112) von einer Vorderoberflächenseite und einer Rückoberflächenseite bedecken,
die Isolierschichten ein Via (141, 116) aufweisen und das Leiterbild (143, 118) an den Isolierschichten (111, 113) mit dem Leiterbild (132, 133) des flexiblen Basismaterials (131) durch das Via (141, 116) verbunden ist.

7. Starr-flexible Leiterplatte nach Anspruch 1, ferner mit:
einer oberen Isolierschicht (144, 145, 114, 115), die an den Isolierschichten (111, 113) ausgebildet ist; und
einem oberen Leiterbild (150, 123, 193, 194), das an der oberen Isolierschicht (144, 145, 114, 115) ausgebildet ist,
wobei das Leiterbild (150, 123, 193, 194) an den Isolierschichten (111, 113) und das obere Leiterbild (150, 123, 193, 194) miteinander durch ein oberes Via (146, 147, 119, 121) verbunden sind, das mit einem Plattiermetall (148, 149, 120, 122) gefüllt ist, und
die obere Isolierschicht (144, 145, 114, 115) aus einer Harzschicht besteht, die durch eine Härtebehandlung bearbeitet ist und ein anorganisches Material aufweist.

8. Starr-flexible Leiterplatte nach Anspruch 1, ferner mit:
einer ersten oberen Isolierschicht (144, 114), die an den Isolierschichten (111, 113) ausgebildet ist; und
einem ersten oberen Leiterbild, das an der ersten oberen Isolierschicht (111, 113) ausgebildet ist;
einer zweiten oberen Isolierschicht (145, 115), die an dem ersten oberen Leiterbild (193, 194) ausgebildet ist; und
einem zweiten oberen Leiterbild (150, 123), das an der zweiten oberen Isolierschicht (145, 115) ausgebildet ist,
wobei das Leiterbild (143, 118) an den Isolierschichten (111, 113) und das erste obere Leiterbild (193, 194) miteinander durch ein erstes oberes Via (146, 119) verbunden sind, das mit einem Plattiermetall (148, 120) gefüllt ist, und
die zweite obere Isolierschicht (145, 115) ein zweites oberes Via (147, 121) aufweist, das etwa über dem ersten oberen Via (146, 119) angeordnet ist, das das erste obere Leiterbild (193, 194) und das zweite obere Leiterbild (150, 123) verbindet und das mit einem Plattiermetall (149, 122) verbunden ist.

9. Starr-flexible Leiterplatte nach Anspruch 1,
bei der eine obere Isolierschicht (144, 114, 145, 115) an den Isolierschichten (111, 113) ausgebildet ist,
ein oberes Via (146, 119, 147, 121) in der oberen Isolierschicht (144, 114, 145, 115) ausgebildet ist und mit dem Leiterbild (143, 118) an den Isolierschichten (111, 113) verbunden ist und
ein Leiterbild (150, 123, 193, 194), das mit dem oberen Via (146, 119, 147, 121) verbunden ist, an der oberen Isolierschicht (144, 114, 145, 115) ausgebildet ist.

10. Starr-flexible Leiterplatte nach Anspruch 9,
bei der die obere Isolierschicht (144, 114, 145, 115) ein Glasfasergewebe aufweist.

11. Starr-flexible Leiterplatte nach Anspruch 1,
bei der eine Harzkupferfilmlage (114, 115) auf die Isolierschichten (111, 113) laminiert ist und ein Harz der Harzkupferfilmlage (114, 115) durch eine Härtebehandlung bearbeitet ist.

12. Starr-flexible Leiterplatte nach Anspruch 1,
bei der ein Via (141, 116) in den Isolierschichten (111, 113) ausgebildet ist und
das Leiterbild (143, 118) an den Isolierschichten (111, 113) mit dem Leiterbild (132, 133) des flexiblen Basismaterials (131) durch das Via (141, 116) verbunden ist.

13. Starr-flexible Leiterplatte nach Anspruch 12,
bei der eine obere Isolierschicht (144, 145, 114, 115), die ein anorganisches Material aufweist, an den Isolierschichten (111, 113) ausgebildet ist,
ein oberes Leiterbild (150, 123, 193, 194) an der oberen Isolierschicht (144, 145, 114, 115) ausgebildet ist,
das Leiterbild (143, 118) an den Isolierschichten (111, 113) und das obere Leiterbild (150, 123, 193, 194) miteinander durch ein oberes Via (146, 119, 147, 121) verbunden sind, das in der oberen Isolierschicht (144, 145, 114, 115) ausgebildet ist und das mit einem Plattiermetall (148, 149, 120, 122) gefüllt ist.

14. Starr-flexible Leiterplatte nach Anspruch 12,
bei der eine Harzschicht (144, 114), die ein Harz aufweist, an den Isolierschichten angeordnet ist und
das Harz der Harzschicht in das Via (141, 116) gefüllt ist.

15. Starr-flexible Leiterplatte nach Anspruch 12,
bei der das Via mit einem Metall gefüllt ist.

16. Starr-flexible Leiterplatte nach Anspruch 12,
bei der das Via (141, 116) zumindest eine der Isolierschichten durchdringt und mit einem Plattiermetall (142, 117) gefüllt ist,
eine obere Isolierschicht (144, 114, 145, 115), die ein anorganisches Material aufweist, und ein oberes Leiterbild (150, 123, 193, 194) an die Isolierschichten (111, 113) laminiert sind,
ein oberes Via (146, 147, 119, 121), das das Leiterbild an den Isolierschichten (111, 113) und das obere Leiterbild verbindet, in der oberen Isolierschicht (144, 114, 145, 115) ausgebildet ist und
das obere Via (146, 147, 119, 121) mit dem Via verbunden ist, das mit dem Plattiermetall gefüllt ist.

17. Starr-flexible Leiterplatte nach Anspruch 12,
bei der sich das Leiterbild (151, 124) an den Isolierschichten über einen Grenzbereich zwischen dem flexiblen Basismaterial und dem nicht-flexiblen Basismaterial erstreckt und eine Stelle erreicht, die den Endabschnitten der Isolierschichten entspricht.

18. Starr-flexible Leiterplatte nach Anspruch 12,
bei der eine ebene Leiterschicht (151, 124) an den Isolierschichten an einem Endabschnitt der Seite des flexiblen Basismaterials ausgebildet ist.

19. Starr-flexible Leiterplatte nach Anspruch 12,
bei der das flexible Basismaterial zum Verbinden mit den Vias Verbindungsplättchen (13b) aufweist,
die Teilung der Verbindungsplättchen größer als die Teilung der Leiterbilder (13a) ist, die an dem flexiblen Basismaterial ausgebildet sind, und
die Leiterbilder derart ausgebildet sind, dass sie die Teilung davon zu den Verbindungsplättchen vergrößern, und elektrisch mit den entsprechenden Verbindungsplättchen verbunden sind.

20. Starr-flexible Leiterplatte nach Anspruch 12,
bei der eine obere Isolierschicht (144, 145, 114, 115), die ein anorganisches Material aufweist, an den Isolierschichten angeordnet ist und
ein oberes Leiterbild (150, 123, 193, 194) an der oberen Isolierschicht ausgebildet ist,
das Leiterbild an den Isolierschichten und das obere Leiterbild miteinander durch ein oberes Via verbunden sind, das in der oberen Isolierschicht ausgebildet ist, und
Endoberflächen der Isolierschichten an der Seite des flexiblen Basismaterials über eine Endoberfläche der oberen Isolierschicht an der Seite des flexiblen Basismaterials vorstehen.

21. Starr-flexible Leiterplatte nach Anspruch 12,
bei der eine obere Isolierschicht (144, 145, 114, 115), die ein anorganisches Material aufweist, an den Isolierschichten ausgebildet ist,
ein oberes Leiterbild (150, 123, 193, 194) an der oberen Isolierschicht ausgebildet ist,
das Leiterbild an den Isolierschichten und das obere Leiterbild miteinander durch ein oberes Via (146, 147, 119, 121) verbunden sind, das in der oberen Isolierschicht ausgebildet ist, und
das obere Via mit einem gehärteten Produkt einer leitfähigen Paste gefüllt ist.

22. Starr-flexible Leiterplatte nach Anspruch 1,
bei der das flexible Basismaterial (131) mit einer Schutzschicht (138, 139) versehen ist, die das Leiterbild bedeckt,
wobei das Leiterbild des flexiblen Basismaterials und das Leiterbild an den Isolierschichten miteinander durch ein Via (141, 116) verbunden sind, das in den Isolierschichten ausgebildet ist.

23. Starr-flexible Leiterplatte nach Anspruch 22,
bei der das Via, das in den Isolierschichten vorgesehen ist, durch die Schutzschicht hindurchdringt.

24. Starr-flexible Leiterplatte nach Anspruch 22,
bei der das Leiterbild, das an den Isolierschichten ausgebildet ist, und das Leiterbild des flexiblen Basismaterials miteinander mit dem Via verbunden sind, das in den Isolierschichten ausgebildet ist und das die Schutzschicht durchdringt.

25. Starr-flexible Leiterplatte nach Anspruch 22,
bei der eine Isolierschicht (134, 135) zwischen dem Leiterbild und der Schutzschicht ausgebildet ist,
das Via (141, 116) derart ausgebildet ist, dass es die Isolierschicht durchdringt,
die Schutzschicht in einem Bereich vorgesehen ist, in dem das Via nicht ausgebildet ist, und
ein Raum zwischen dem nicht-flexiblen Basismaterial und der Schutzschicht und um den Rand des Vias mit einem Harz (125) gefüllt ist.

26. Starr-flexible Leiterplatte nach Anspruch 22,
bei der die Schutzschicht (138, 139) in einem Bereich vorgesehen ist, in dem das Via nicht ausgebildet ist,
die Dicke des flexiblen Basismaterials, das die Schutzschicht aufweist, kleiner als die Dicke des nicht-flexiblen Basismaterials ist,
ein Raum zwischen der Schutzschicht und den Isolierschichten und um den Randabschnitt des Vias mit einem Harz (125) gefüllt ist, das ein anorganisches Material aufweist, und
das Harz integral mit den Isolierschichten gehärtet ist.

27. Starr-flexible Leiterplatte nach Anspruch 22,
bei der das flexible Basismaterial mit dem Leiterbild und der zumindest einen Schutzschicht versehen ist, die das Leiterbild bedeckt, wobei die Dicke des flexiblen Basismaterials, das die Schutzschicht aufweist, etwa gleich der des nicht-flexiblen Basismaterials ist,
die Schutzschicht in einem Bereich vorgesehen ist, in dem das Via nicht ausgebildet ist, und
ein Raum zwischen dem nicht-flexiblen Basismaterial und der Schutzschicht und um den Rand des Vias mit einem Harz (125) gefüllt ist, das ein anorganisches Material aufweist.

28. Starr-flexible Leiterplatte nach Anspruch 22,
bei der das flexible Basismaterial mit dem Leiterbild und der Schutzschicht versehen ist, die das Leiterbild bedeckt,
die Dicke des flexiblen Basismaterials, das die Schutzschicht aufweist, im Wesentlichen gleich der des nicht-flexiblen Basismaterials ist,
die Schutzschicht in einem Bereich vorgesehen ist, in dem das Via nicht ausgebildet ist,
ein Raum zwischen dem nicht-flexiblen Basismaterial und der Schutzschicht und um den Rand des Vias mit einem Harz (125) gefüllt ist, das ein anorganisches Materials aufweist, und
das Harz integral mit den Isolierschichten gehärtet ist.

29. Starr-flexible Leiterplatte nach Anspruch 22,
bei der das flexible Basismaterial derart ausgebildet ist, dass es eine kleinere Dicke als die des nicht-flexiblen Basismaterials hat.

30. Starr-flexible Leiterplatte nach Anspruch 22,
bei der in dem flexiblen Basismaterial ein Abschnitt, wo das flexible Basismaterial und die Isolierschicht zueinander zeigen und die Harze des flexiblen Basismaterials und der Isolierschicht polymerisiert sind, weiter als ein Abschnitt ist, wo die Harze mit der Isolierschicht nicht polymerisiert sind.

31. Starr-flexible Leiterplatte nach Anspruch 22,
bei der die Weite des flexiblen Basismaterials in einem Grenzbereich mit den Isolierschichten größer als die Weite des anderen Teils des flexiblen Basismaterials ist.

32. Starr-flexible Leiterplatte nach Anspruch 22,
bei der die Schutzschicht einen Isolierfilm (134, 135) aufweist und
ein Via, das in den Isolierschichten (111, 113) ausgebildet ist, den Isolierfilm (134, 135) durchdringt und das Leiterbild (143, 118) an den Isolierschichten (111, 113) und das Leiterbild (132, 133) elektrisch verbindet, das für das flexible Basismaterial (131) ausgebildet ist.

33. Starr-flexible Leiterplatte nach Anspruch 22,
bei der die Schutzschicht (138, 139) des flexiblen Basismaterials (131) eine elektromagnetische Schutzschicht (136, 137) aufweist.

34. Starr-flexible Leiterplatte nach Anspruch 22,
bei der das Leiterbild (132, 133) für das flexible Basismaterial (131) ausgebildet ist, ein Isolierfilm (134, 135) an dem Leiterbild (132, 133) ausgebildet ist und eine elektromagnetische Schutzschicht (136, 137) an dem Isolierfilm (134, 135) ausgebildet ist.

35. Starr-flexible Leiterplatte nach Anspruch 22,
bei der das Leiterbild (132, 133) für das flexible Basismaterial (131) ausgebildet ist,
ein Isolierfilm (134, 135) an dem Leiterbild (132, 133) ausgebildet ist,
eine elektromagnetische Schutzschicht (136, 137) an dem Isolierfilm (134, 136) ausgebildet ist und
die Schutzschicht (138, 139) an der elektromagnetischen Schutzschicht (136, 137) ausgebildet ist.

36. Starr-flexible Leiterplatte nach Anspruch 22,
bei der das Leiterbild (132, 133) an dem flexiblen Basismaterial (131) ausgebildet ist,
ein Isolierfilm (134, 135) an dem Leiterbild (132, 133) ausgebildet ist,
eine elektromagnetische Schutzschicht (136, 137) an dem Isolierfilm (134, 135) ausgebildet ist und
die Schutzschicht (138, 139) an der elektromagnetischen Schutzschicht (136, 137) ausgebildet ist und in Kontakt mit dem Isolierfilm (134, 135) ist.

37. Verfahren zum Herstellen einer starr-flexiblen Leiterplatte, das die folgenden Schritte umfasst:
Anordnen eines nicht-flexiblen Basismaterials (112) und eines flexiblen Basismaterials (131), das mit einem Leiterbild (132, 133) versehen ist, so dass sie aneinander angrenzen, wobei das Leiterbild ein Verbindungsplättchen (138) aufweist,
Bedecken eines Grenzbereichs zwischen dem flexiblen Basismaterial und dem nicht-flexiblen Basismaterial mit Isolierschichten (111, 113), die ein anorganisches Material aufweisen und die mit einem Leiterbild (113, 118) versehen sind,
Ausbilden eines Vias (141, 116), das die Isolierschichten hindurchdringt und das Leiterbild des flexiblen Basismaterials erreicht; und
Verbinden des Leiterbilds des flexiblen Basismaterials und des Leiterbilds an den Isolierschichten durch das Via durch Plattieren (142, 117) auf das Verbindungsplättchen (136), das an dem flexiblen Basismaterial ausgebildet ist, ohne durch das Verbindungsplättchen hindurchzudringen.

38. Verfahren zum Herstellen einer starr-flexiblen Leiterplatte nach Anspruch 37,
bei der die Isolierschichten aus einem Harz gebildet werden, das ein anorganisches Material aufweist,
das Harz, das ein anorganisches Material aufweist, das die Isolierschichten bildet, in einen Raum gefüllt wird, der zwischen dem nicht-flexiblen Basismaterial, dem flexiblen Basismaterial und den Isolierschichten gebildet wird, und
das eingefüllte Harz integral mit den Isolierschichten gehärtet wird.

39. Verfahren zum Herstellen einer starr-flexiblen Leiterplatte nach Anspruch 37,
bei der das Via mit einem Plattiermetall durch Plattieren gefüllt wird.

40. Verfahren zum Herstellen einer starr-flexiblen Leiterplatte nach Anspruch 37,
bei der ein Grenzbereich zwischen dem flexiblen Basismaterial und dem nicht-flexiblen Basismaterial mit den Isolierschichten von einer Vorderoberflächenseite und einer Rückoberflächenseite bedeckt wird.

41. Verfahren zum Herstellen einer starr-flexiblen Leiterplatte nach Anspruch 37,
bei der ein Metallfilm an den Isolierschichten und dem flexiblen Basismaterial angeordnet wird,
eine zweite Isolierschicht, die ein anorganisches Material aufweist, an dem Metallfilm angeordnet wird; und
die zweite Isolierschicht an einer Position, die Endabschnitten der Isolierschichten entspricht, durch Laser unter Verwendung des Metallfilms als Stopper geschnitten wird.

42. Verfahren zum Herstellen einer starr-flexiblen Leiterplatte nach Anspruch 37,
bei der eine Metallfolie an den Isolierschichten und dem flexiblen Basismaterial angeordnet wird,
eine zweite Isolierschicht, die ein anorganisches Material aufweist, an dem Metallfilm angeordnet wird,
die zweite Isolierschicht an einer Position, die Endabschnitten der Isolierschichten entspricht, durch Laser unter Verwendung des Metallfilms als Stopper geschnitten wird und
ein verbleibender Teil an dem flexiblen Basismaterial durch Schneiden unter Verwendung des Lasers zusammen mit dem Metallfilm entfernt wird.

43. Verfahren zum Herstellen einer starr-flexiblen Leiterplatte nach Anspruch 37,
bei der ein Metallfilm an den Isolierschichten und dem flexiblen Basismaterial angeordnet wird,
ein Schaltungsbild über den Isolierschichten durch Mustern des Metallfilms gebildet wird,
eine zweite Isolierschicht, die ein anorganisches Material aufweist, an der Metallfolie angeordnet wird; und
die zweite Isolierschicht an einer Position, die Endabschnitten der Isolierschichten entspricht, durch den Laser unter Verwendung des Metallfilms als Stopper geschnitten wird.

44. Verfahren zum Herstellen einer starr-flexiblen Leiterplatte nach Anspruch 37,
bei der ein Metallfilm an den Isolierschichten und dem flexiblen Basismaterial angeordnet wird,
eine zweite Isolierschicht, die ein anorganisches Material aufweist, an dem Metallfilm angeordnet wird,
ein Leiterbild an der zweiten Isolierschicht ausgebildet wird und
die zweite Isolierschicht an einer Position, die Endabschnitten der Isolierschichten entspricht, durch den Laser unter Verwendung des Metallfilms als Stopper geschnitten wird.

45. Verfahren zum Herstellen einer starr-flexiblen Leiterplatte nach Anspruch 37,
bei der die zweite Isolierschicht aus einem Harz besteht, das ein anorganisches Material aufweist, und
das Via mit dem Harz der zweiten Isolierschicht gefüllt wird.

46. Verfahren zum Herstellen einer starr-flexiblen Leiterplatte nach Anspruch 37,
bei der die Isolierschichten aus einem Harz bestehen, das ein anorganisches Material aufweist.

## Revendications

1. Carte de câblage flexorigide comprenant :
un matériau de base flexible (131) pourvu d'un tracé conducteur (133, 132) ayant un plot de connexion (13b) ;
un matériau de base non flexible (112) disposé de manière adjacente au matériau de base flexible (131) dans une direction horizontale ;
des couches isolantes (111, 113) contenant chacune un matériau inorganique (111a, 111b, 113a, 113b), qui couvrent le matériau de base non flexible (112) et le matériau de base flexible (131), et qui exposent au moins une partie du matériau de base flexible (131) ; et
un tracé conducteur (143, 118) formé sur les couches isolantes (111, 112),
**caractérisé en ce que** le tracé conducteur (132, 133) du matériau de base flexible (131) et le tracé conducteur (143, 118) sur les couches isolantes (111, 113) sont connectés l'un à l'autre par placage (142, 117) sur le plot de connexion (13b) formé sur le matériau de base flexible sans pénétration dans le plot de connexion.

2. Carte de câblage flexorigide selon la revendication 1,
dans lequel le matériau de base flexible (131) et le matériau de base non flexible (112) sont disposés avec un espace prévu entre eux, et
l'espace est rempli avec une résine (125) contenant un matériau inorganique.

3. Carte de câblage flexorigide selon la revendication 1,
dans lequel le matériau de base flexible (131) et le matériau de base non flexible (112) sont disposés avec un espace prévu entre eux,
l'espace est rempli avec une résine (125) contenant un matériau inorganique, et
la résine (125) est durcie solidairement avec les couches isolantes (111, 113).

4. Carte de câblage flexorigide selon la revendication 1,
dans lequel un tracé conducteur (191, 192) est formé sur une surface du matériau de base non flexible (131).

5. Carte de câblage flexorigide selon la revendication 1,
dans lequel les couches isolantes (111, 113) couvrent une région frontière entre une partie d'extrémité du matériau de base flexible (131) et une partie d'extrémité du matériau de base non flexible (112) à partir d'un côté de surface avant et d'un côté de surface arrière.

6. Carte de câblage flexorigide selon la revendication 1,
dans lequel les couches isolantes (111, 113) couvrent une région frontière entre une partie d'extrémité du matériau de base flexible (131) et une partie d'extrémité du matériau de base non flexible (112) à partir d'un côté de surface avant et d'un côté de surface arrière,
les couches isolantes présentent un trou d'interconnexion (141, 116), et
le tracé conducteur (143, 118) sur les couches isolantes (111, 113) est connecté au tracé conducteur (132, 133) du matériau de base flexible (131) par l'intermédiaire du trou d'interconnexion (141, 116).

7. Carte de câblage flexorigide selon la revendication 1, comprenant en outré :
une couche isolante supérieure (144, 145, 114, 115) formée sur les couches isolantes (111, 113) ; et
un tracé conducteur supérieur (150, 123, 193, 194) formé sur la couche isolante supérieure (144, 145, 114, 115),
où le tracé conducteur (150, 123, 193, 194) sur les couches isolantes (111, 113) et le tracé conducteur supérieur (150, 123, 193, 194) sont connectés l'un à l'autre par l'intermédiaire d'un trou d'interconnexion supérieur (146, 147, 119, 121) rempli avec un métal de placage (148, 149, 120, 122), et
la couche isolante supérieure (144, 145, 114, 115) est composée d'une couche de résine traitée par un traitement de durcissement et contient un matériau inorganique.

8. Carte de câblage flexorigide selon la revendication 1, comprenant en outre :
une première couche isolante supérieure (144, 114) formée sur les couches isolantes (111, 113) ;
un premier tracé conducteur supérieur formé sur la première couche isolante supérieure (111, 113) ;
une deuxième couche isolante supérieure (145, 115) formée sur le premier tracé conducteur supérieur (193, 194) ; et
un deuxième tracé conducteur supérieur (150, 123) formé sur la deuxième couche isolante supérieure (145, 115),
où le tracé conducteur (143, 118) sur les couches isolantes (111, 113) et le premier tracé conducteur supérieur (193, 194) sont connectés l'un à l'autre par l'intermédiaire d'un premier trou d'interconnexion supérieur (146, 119) rempli avec un métal de placage (148, 120), et
la deuxième couche isolante supérieure (145, 115) présente un deuxième trou d'interconnexion supérieur (147, 121) qui est situé approximativement sur le premier trou d'interconnexion supérieur (146, 119), qui connecte le premier tracé conducteur supérieur (193, 194) et le deuxième tracé conducteur supérieur (150, 123), et qui est rempli avec un métal de placage (149, 122).

9. Carte de câblage flexorigide selon la revendication 1,
dans lequel une couche isolante supérieure (144, 114, 145, 115) est formée sur les couches isolantes (111, 113), un trou d'interconnexion supérieur (146, 119, 147, 121) est formé dans la couche isolante supérieure (144, 114, 145, 115) et est connecté au tracé conducteur (143, 118) sur les couches isolantes (111, 113), et
un tracé conducteur (150, 123, 193, 194) connecté au premier trou d'interconnexion supérieur (146, 119, 147, 121) est formé sur la couche isolante supérieure (144, 114, 145, 115),

10. Carte de câblage flexorigide selon la revendication 9,
dans lequel la couche isolante supérieure (144, 114, 145, 115) comporte un tissu de verre.

11. Carte de câblage flexorigide selon la revendication 1,
dans lequel un film de feuille de cuivre recouverte de résine (114, 115) est stratifié sur les couches isolantes (111, 113), et
une résine du film de feuille de cuivre recouverte de résine (114, 115) est traitée par un traitement de durcissement.

12. Carte de câblage flexorigide selon la revendication 1,
dans lequel un trou d'interconnexion (141, 116) est formé dans les couches isolantes (111, 113), et
le tracé conducteur (143, 118) sur les couches isolantes (111, 113) est connecté au tracé conducteur (132, 133) du matériau de base flexible (131) par l'intermédiaire du trou d'interconnexion (141, 116).

13. Carte de câblage flexorigide selon la revendication 12,
dans lequel une couche isolante supérieure (144, 145, 114, 115) contenant un matériau inorganique est formée sur les couches isolantes (111, 113),
un tracé conducteur supérieur (150, 123, 193, 194) est formé sur la couche isolante supérieure (144, 145, 114, 115),
le tracé conducteur (143, 118) sur les couches isolantes (111, 113) et le tracé conducteur supérieur (150, 123, 193, 194) sont connectés l'un à l'autre par l'intermédiaire d'un trou d'interconnexion supérieur (146, 119, 147, 121) qui est formé dans la couche isolante supérieure (144, 145, 114, 115) et qui est rempli avec un métal de placage (148, 149, 120, 122).

14. Carte de câblage flexorigide selon la revendication 12,
dans lequel une couche de résine (144, 114) contenant une résine est disposée sur les couches isolantes, et
la résine de la couche de résine est introduite dans le trou d'interconnexion (141, 116).

15. Carte de câblage flexorigide selon la revendication 12,
dans lequel le trou d'interconnexion est rempli avec un métal.

16. Carte de câblage flexorigide selon la revendication 12,
dans lequel le trou d'interconnexion (141, 116) pénètre dans au moins l'une des couches isolantes (111, 113) et est rempli avec un métal de placage (142, 117),
une couche isolante supérieure (144, 114, 145, 115) contenant un matériau inorganique et un tracé conducteur supérieur (150, 123, 193, 194) sont stratifiés sur les couches isolantes (111, 113),
un trou d'interconnexion supérieur (146, 147, 119, 121) connectant le tracé conducteur sur les couches isolantes (111, 113) et le tracé conducteur supérieur est formé dans la couche isolante supérieure (144, 114, 145, 115), et
le trou d'interconnexion supérieur (146, 147, 119, 121) est connecté au trou d'interconnexion rempli avec le métal de placage.

17. Carte de câblage flexorigide selon la revendication 12,
dans lequel le tracé conducteur (151, 124) sur les couches isolantes s'étend au-dessus d'une région frontière entre le matériau de base flexible et le matériau de base non flexible et atteint un emplacement correspondant à des parties d'extrémité des couches isolantes.

18. Carte de câblage flexorigide selon la revendication 12,
dans lequel une couche conductrice planaire (151, 124) est formée sur les couches isolantes au niveau d'une partie d'extrémité au côté matériau de base flexible.

19. Carte de câblage flexorigide selon la revendication 12,
dans lequel le matériau de base flexible présente des plots de connexion (13b) devant être connectés aux trous d'interconnexion,
le pas des plots de connexion est plus grand que le pas des tracés conducteurs (13a) formés sur le matériau de base flexible, et
les tracés conducteurs sont formés de manière à augmenter leur pas vers les plots de connexion et sont électriquement connectés aux plots de connexion respectifs.

20. Carte de câblage flexorigide selon la revendication 12,
dans lequel une couche isolante supérieure (144, 145, 114, 115) contenant un matériau inorganique est formée sur les couches isolantes, et
un tracé conducteur supérieur (150, 123, 193, 194) est formé sur la couche isolante supérieure,
le tracé conducteur sur les couches isolantes et le tracé conducteur supérieur sont connectés l'un à l'autre par l'intermédiaire d'un trou d'interconnexion supérieur formé dans la couche isolante supérieure, et
des surfaces d'extrémité des couches isolantes au niveau du côté matériau de base flexible dépassent une surface d'extrémité de la couche isolante supérieure au niveau du côté matériau de base flexible.

21. Carte de câblage flexorigide selon la revendication 12,
dans lequel une couche isolante supérieure (144, 145, 114, 115) contenant un matériau inorganique est formée sur les couches isolantes,
un tracé conducteur supérieur (150, 123, 193, 194) est formé sur la couche isolante supérieure,
le tracé conducteur sur les couches isolantes et le tracé conducteur supérieur sont connectés l'un à l'autre par l'intermédiaire d'un trou d'interconnexion supérieur (146, 147, 119, 121) formé dans la couche isolante supérieure, et
le trou d'interconnexion supérieur est rempli avec un produit durci d'une pâte conductrice.

22. Carte de câblage flexorigide selon la revendication 1, dans lequel
le matériau de base flexible (131) est pourvu d'une couche de protection (138, 139) couvrant le tracé conducteur ;
où le tracé conducteur du matériau de base flexible et le tracé conducteur sur les couches isolantes sont connectés l'un à l'autre par l'intermédiaire d'un trou d'interconnexion (141, 116) formé dans les couches isolantes.

23. Carte de câblage flexorigide selon la revendication 22,
dans lequel le trou d'interconnexion prévu dans les couches isolantes pénètre dans la couche de protection.

24. Carte de câblage flexorigide selon la revendication 22,
dans lequel le tracé conducteur formé sur les couches isolantes et le tracé conducteur du matériau de base flexible sont connectés l'un à l'autre par le trou d'interconnexion qui est formé dans les couches isolantes et qui pénètre dans la couche de protection.

25. Carte de câblage flexorigide selon la revendication 22,
dans lequel une couche isolante (134, 135) est formée entre le tracé conducteur et la couche de protection,
le trou d'interconnexion (141, 116) est formé de manière à pénétrer dans la couche isolante,
la couche de protection est prévue dans une région dans laquelle le trou d'interconnexion n'est pas formé, et
un espace entre le matériau de base non flexible et la couche de protection et autour de la périphérie du trou d'interconnexion est rempli avec une résine (125).

26. Carte de câblage flexorigide selon la revendication 22,
dans lequel la couche de protection (138, 139) est prévue dans une région dans laquelle le trou d'interconnexion n'est pas formé,
l'épaisseur du matériau de base flexible comportant la couche de protection est inférieure à l'épaisseur du matériau de base non flexible,
un espace entre la couche de protection et les couches isolantes et autour de la partie périphérique du trou d'interconnexion est rempli avec une résine (125) qui contient un matériau inorganique, et
la résine est durcie solidairement avec les couches isolantes.

27. Carte de câblage flexorigide selon la revendication 22,
dans lequel le matériau de base flexible est pourvu du tracé conducteur et ladite au moins une couche de protection couvrant le tracé conducteur, l'épaisseur du matériau de base flexible comportant la couche de protection étant approximativement équivalente à celle du matériau de base non flexible,
la couche de protection est prévue dans une région dans laquelle le trou d'interconnexion n'est pas formé, et
un espace entre le matériau de base non flexible et la couche de protection et autour de la périphérie du trou d'interconnexion est rempli avec une résine (125) contenant un matériau inorganique.

28. Carte de câblage flexorigide selon la revendication 22,
dans lequel le matériau de base flexible est pourvu du tracé conducteur et la couche de protection couvrant le tracé conducteur,
l'épaisseur du matériau de base flexible comportant la couche de protection est approximativement équivalente à celle du matériau de base non flexible,
la couche de protection est prévue dans une région dans laquelle le trou d'interconnexion n'est pas formé,
un espace entre le matériau de base non flexible et la couche de protection et autour de la périphérie du trou d'interconnexion est rempli avec une résine (125) contenant un matériau inorganique, et
la résine est durcie solidairement avec les couches isolantes.

29. Carte de câblage flexorigide selon la revendication 22,
dans lequel le matériau de base flexible est formé de façon à avoir une épaisseur inférieure à celle du matériau de base non flexible.

30. Carte de câblage flexorigide selon la revendication 22,
dans lequel, dans le matériau de base flexible, une partie où le matériau de base flexible et la couche isolante se faisant face mutuellement et les résines du matériau de base flexible et de la couche isolante sont polymérisées est plus large qu'une partie où les résines ne sont pas polymérisées avec la couche isolante.

31. Carte de câblage flexorigide selon la revendication 22,
dans lequel la largeur du matériau de base flexible dans une région frontière avec les couches isolantes est plus importante que la largeur de l'autre partie du matériau de base flexible.

32. Carte de câblage flexorigide selon la revendication 22,
dans lequel la couche de protection comporte un film isolant (134, 135), et
un trou d'interconnexion formé dans les couches isolantes (111, 113) pénètre dans le film isolant (134, 135) et connecte électriquement le tracé conducteur (143, 118) sur les couches isolantes (111, 113) et le tracé conducteur (132, 133) formé sur le matériau de base flexible (131).

33. Carte de câblage flexorigide selon la revendication 22,
dans lequel la couche de protection (138, 139) du matériau de base flexible (131) comporte une couche de protection électromagnétique (136, 137).

34. Carte de câblage flexorigide selon la revendication 22,
dans lequel le tracé conducteur (132, 133) est formé sur le matériau de base flexible (131), un film isolant (134, 135) est formé sur le tracé conducteur (132, 133), et une couche de protection électromagnétique (136, 137) est formée sur le film isolant (134, 135).

35. Carte de câblage flexorigide selon la revendication 22,
dans lequel le tracé conducteur (132, 133) est formé sur le matériau de base flexible (131),
un film isolant (134, 135) est formé sur le tracé conducteur (132, 133),
une couche de protection électromagnétique (136, 137) est formée sur le film isolant (134, 135), et
la couche de protection (138, 139) est formée sur la couche de protection électromagnétique (136, 137).

36. Carte de câblage flexorigide selon la revendication 22,
dans lequel le tracé conducteur (132, 133) est formé sur le matériau de base flexible (131),
un film isolant (134, 135) est formé sur le tracé conducteur (132, 133),
une couche de protection électromagnétique (136, 137) est formée sur le film isolant (134, 135), et
la couche de protection (138, 139) est formée sur la couche de protection électromagnétique (136, 137) et est en contact avec le film isolant (134, 135).

37. Procédé de fabrication d'une carte de câblage flexorigide, comprenant les étapes qui consistent :
à disposer un matériau de base non flexible (112) et un matériau de base flexible (131) pourvu d'un tracé conducteur (132, 133) de manière à être adjacents l'un à l'autre, le tracé conducteur ayant un plot de connexion (13b),
à couvrir une région frontière entre le matériau de base flexible et le matériau de base non flexible avec des couches isolantes (111, 113) qui contiennent un matériau inorganique, et qui sont pourvues d'un tracé conducteur (143, 118),
à former un trou d'interconnexion (141, 116) qui pénètre dans les couches isolantes et qui atteint le tracé conducteur du matériau de base flexible ; et
à connecter le tracé conducteur du matériau de base flexible et le tracé conducteur sur les couches isolantes par l'intermédiaire du trou d'interconnexion par placage (142, 117) sur le plot de connexion (13b) formé sur le matériau de base flexible sans pénétration dans le plot de connexion.

38. Procédé de fabrication d'une carte de câblage flexorigide, selon la revendication 37,
dans lequel les couches isolantes sont formées d'une résine contenant un matériau inorganique,
la résine contenant un matériau inorganique, qui forme les couches isolantes, est introduite dans un espace formé entre le matériau de base non flexible, le matériau de base flexible, et les couches isolantes, et
la résine introduite est durcie solidairement avec les couches isolantes.

39. Procédé de fabrication d'une carte de câblage flexorigide, selon la revendication 37,
dans lequel le trou d'interconnexion est rempli avec un métal de placage par placage.

40. Procédé de fabrication d'une carte de câblage flexorigide, selon la revendication 37,
dans lequel une région frontière entre le matériau de base flexible et le matériau de base non flexible est recouverte par les couches isolantes à partir d'un côté de surface avant et d'un côté de surface arrière.

41. Procédé de fabrication d'une carte de câblage flexorigide, selon la revendication 37,
dans lequel une feuille métallique est disposée sur les couches isolantes et le matériau de base flexible,
une deuxième couche isolante contenant un matériau inorganique est disposée sur la feuille métallique ; et
la deuxième couche isolante à une position correspondant à des parties d'extrémité des couches isolantes est découpée au laser en utilisant la feuille métallique comme une butée.

42. Procédé de fabrication d'une carte de câblage flexorigide, selon la revendication 37,
dans lequel une feuille métallique est disposée sur les couches isolantes et le matériau de base flexible,
une deuxième couche isolante contenant un matériau inorganique est disposée sur la feuille métallique ;
la deuxième couche isolante à une position correspondant à des parties d'extrémité des couches isolantes est découpée au laser en utilisant la feuille métallique comme une butée, et
une partie restante sur le matériau de base flexible par découpage à l'aide du laser est enlevée conjointement avec la feuille métallique.

43. Procédé de fabrication d'une carte de câblage flexorigide, selon la revendication 37,
dans lequel une feuille métallique est disposée sur les couches isolantes et le matériau de base flexible,
un tracé de circuit est formé sur les couches isolantes par mise en forme de la feuille métallique,
une deuxième couche isolante contenant un matériau inorganique est disposée sur la feuille métallique ; et
la deuxième couche isolante à une position correspondant à des parties d'extrémité des couches isolantes est découpée au laser en utilisant la feuille métallique comme une butée.

44. Procédé de fabrication d'une carte de câblage flexorigide, selon la revendication 37,
dans lequel une feuille métallique est disposée sur les couches isolantes et le matériau de base flexible,
une deuxième couche isolante contenant un matériau inorganique est disposée sur la feuille métallique,
un tracé conducteur est formé sur la deuxième couche isolante, et
la deuxième couche isolante à une position correspondant à des parties d'extrémité des couches isolantes est découpée au laser en utilisant la feuille métallique comme une butée,

45. Procédé de fabrication d'une carte de câblage flexorigide, selon la revendication 37,
dans lequel la deuxième couche isolante est composée d'une résine contenant un matériau inorganique, et
le trou d'interconnexion est rempli avec la résine de la deuxième couche isolante.

46. Procédé de fabrication d'une carte de câblage flexorigide, selon la revendication 37,
dans lequel les couches isolantes sont composées d'une résine contenant un matériau inorganique.
